# EUROPÄISCHE PATENTSCHRIFT

(11) **EP 2 683 779 B1**
(45) Veröffentlichungstag und Bekanntmachung des Hinweises auf die Patenterteilung: **06.01.2016**
(21) Anmeldenummer: 12703458.5
(22) Anmeldetag: 09.02.2012
(51) Int. Cl.: C09D 11/30, C09D 11/02

(54) **FORMULIERUNGEN VON DRUCKBAREN ALUMINIUMOXIDTINTEN**
FORMULATIONS OF PRINTABLE ALUMINIUM OXIDE INKS
FORMULATIONS D'ENCRES IMPRIMABLES À BASE D'OXYDE D'ALUMINIUM

(30) Priorität: 08.03.2011 EP 11001920; 06.09.2011 EP 11007207
(43) Veröffentlichungstag der Anmeldung: 15.01.2014
(73) Patentinhaber: Merck Patent GmbH, 64293 Darmstadt (DE)
(72) Erfinder: KOEHLER, Ingo, 64354 Reinheim (DE); DOLL, Oliver, 63128 Dietzenbach (DE); STOCKUM, Werner, 64354 Reinheim (DE); BARTH, Sebastian, 64291 Darmstadt (DE)
(86) Internationale Anmeldenummer: PCT/EP2012/000591
(87) Internationale Veröffentlichungsnummer: WO 2012/119685

(56) Entgegenhaltungen:
- EP-A1- 0 887 200
- WO-A1-02/03413
- CN-A- 101 030 540
- GB-A- 2 403 214
- US-A- 4 997 482
- US-A1- 2008 090 101

## Beschreibung

Die vorliegende Erfindung betrifft die Verwendung von druckbaren Tinten zur Ausbildung von Al₂O₃-Beschichtungen oder von gemischten Al₂O₃-HybridSchichten, sowie ein entsprechendes Verfahren zu deren Bildung.

Die Synthese von Sol-Gel basierten Schichten erlangt in der industriellen Produktion aufgrund ihrer vielseitigen Einsatzmöglichkeiten immer mehr an Bedeutung. So können mittels Sol-Gel-Technologie folgende funktionale Schichten bzw. Oberflächenveredelungen und -modifikationen aufgebaut bzw. durchgeführt werden:
- Antireflexbeschichtungen, beispielsweise für optische Bauteile und dergleichen
- Korrosionsschutzbeschichtungen, beispielsweise von Stählen und dergleichen
- Kratzschutzbeschichtungen
- Oberflächenversiegelungen
- Hydrophobisierungen bzw. Hydrophilierungen von Oberflächen
- Synthesen von Membranen und Membranmaterialien
- Synthesen von Trägermaterialien für katalytische Applikationen
- Vorstufen für Sinterkeramiken und -keramische Bauteile
- Dielektrische Schichten für elektronische und mikroelektronische Bauteile mit folgenden Spezialanwendungen, wobei die Ausbildung einer der erwünschten Funktionalitäten mit spezieller Temperbehandlung, wie beispielsweise im O₂-, N₂-, O₂/N₂- und/oder Formiergasstrom, verknüpft sein kann, jedoch nicht sein muss.
   ∘ Spin-on-glass ("SoG") bei der Fertigung integrierter Schaltungen
   ∘ Dielektrische Pufferschichten zwischen einzelnen Metallisierungsebenen bei der Fertigung integrierter Schaltkreise ("porous MSQ")
   ∘ Druckbare dielektrische Schichten für gedruckte Schaltungen, druckbare Elektronik im Allgemeinen und druckbare organische Elektronik im Speziellen
   ∘ Druckbare dielektrische Schichten für elektrische Schaltungen und Schaltkreise
- Diffusionssperrschichten (WO 2009/118083 A2)
   ∘ für Halbleiter im Allgemeinen,
   ∘ für Silicium im Speziellen, und hierbei im Besonderen für Siliciumwafer, und dabei insbesondere für solche zur Herstellung kristalliner Siliciumsolarzellen
   • Matrices zur Einbindung von Dotierstoffen (beispielsweise B, Ga, P, As usw.) zum gezielten ganzflächigen und/oder lokalen Dotieren von
   ∘ Halbleitern im Allgemeinen,
   ∘ Silicium im Speziellen und hierbei im Besonderen für Siliciumwafer und dabei insbesondere für solche zur Herstellung kristalliner Siliciumsolarzellen,
- elektronische Passivierung von Halbleiteroberflächen im Allgemeinen, und von Silicium im Speziellen.

Diese Auflistung gibt nur einen Ausschnitt der vielfältigen Applikationsmöglichkeiten wieder.

Die meisten literaturbekannten Sol-Gel-Prozesse beruhen auf der Verwendung von Silicium und dessen Alkoxiden (Siloxanen), durch deren gezielte Hydrolyse und Kondensation sehr leicht Netzwerke mit unterschiedlichen Eigenschaften und daraus ableitbaren Beschichtungen synthetisiert werden können, und es können glatte oder poröse Filme, aber auch Filme, in welche Partikel eingebettet sind, hergestellt werden.

Für die Anwendung, insbesondere im Solarbereich, haben Sol-Gel-basierte Schichten besondere Anforderungen zu erfüllen. Diese sind auch bei der Formulierung von Zusammensetzungen zu berücksichtigen, die zur Herstellung solcher Schichten einsetzbar sind. Insbesondere zur Herstellung der erforderlichen dünnen Schichten sind besonders Tinten geeignet. Jedoch sind an die Zusammensetzung der Tinten spezielle Anforderungen zu stellen, so dass die herzustellenden Schichten durch die Synthese und die eingesetzten Edukte die gewünschten grundlegenden Eigenschaften erhalten: Einerseits sind geeignete Lösungsmittel mit für die Verwendung vorteilhaften Eigenschaften auszuwählen, wie beispielsweise keine bis geringe Toxizität oder ausreichende Oberflächenbenetzung. Weiterhin sollten in den Tinten keine korrodierend wirkenden Anionen (Cl⁻ oder NO₃⁻, etc.) enthalten sein, da diese die Einsatzmöglichkeiten der Tinten stark limitieren würden. Entsprechende Tinten könnten beispielsweise die zur Anwendung kommenden Druck- und Depositionseinrichtungen korrodieren, aber auch später Korrosion unerwünscht fördern, wie z. B. von Lötkontakten bei der Verschaltung von Solarzellen, welche mit solchen Schichten versehen sind, was dadurch bedingt zu einer begrenzten Langzeitstabilität von kristallinen Silicium-Solarmodulen führen würde.

Aus der Literatur sind neben wässrigen, nach Yoldas benannten Tinten, viele Beispiele für ionisch und sterisch stabilisierte Tinten bekannt [1 - 3].

Özer et al. [1] und Felde et al. [2] beschreiben eine homogene Filmbildung auf Siliziumwafern bzw. Diamanten durch ein sterisch-anionisch stabilisiertes Sol. Das Auftreten von Niederschlägen bei nur mit Acetylaceton stabilisierten Solen (ohne HNO₃) wird von Nass et al. [3] untersucht. Diese zeigen außerdem, dass durch Nutzung von Ethylacetoacetat in einer alkoholischen Aluminiumalkoholatlösung die Hydrolyse kontrolliert eingestellt werden kann und es zu keiner Alterung der Sole unter Niederschlagsbildung, Gelierung kommt.
[1] N. Özer, J.P. Cronin, Y. Yao, A.P. Tomsia, Solar Energy Materials & Solar Cells 59 (1999) 355-366
[2] B. Felde, A. Mehner, J. Kohlscheen, R. Glabe, F. Hoffmann and P. Mayr, Diamond and Related Materials, 10 (2001), 515-518
[3] R. Nass, H. Schmidt, Journal of non-crystalline Solids, 121 (1990), 329-333

Neben dem Verzicht auf stabilisierende und korrodierend wirkende Ionen sollten die Tinten vor allem für den Einsatz als Diffusionsbarriere geeignet sein und dichte, d. h. gegenüber des jeweils zum Einsatz gelangenden Dotanden diffusionsdichte Schichten ausbilden können. Des Weiteren sollten die Tinten über einen längeren Zeitraum lagerungsstabil sein, um deren Anwendung von der Synthese der Tinten entkoppeln zu können. Bei nicht ionisch stabilisierten Tinten wird in der Literatur meist über eine geringe Langzeitstabilität oder die Bildung von stabilisierten Partikeln, die zu porösen Schichten führen, berichtet.

Nur Sole mit Ethylacetoacetat oder Triethanolamin zeigen eine ausreichend hohe Langzeitstabilität bei klein bleibender Partikelgrösse. Zum anderen können Sole ohne Wasserzugabe als langzeitstabile Sole synthetisiert werden.

Gonzales-Pena et al. [4] sowie Tadanaga et al. [6] zeigten, dass ASB modifiziert mit Triethanolamin eine hohe Hydrolysestabilität besitzt. Außerdem folgerten sie aus der Gelstruktur sowie aus Untersuchungen in Lösung, dass durch die gut stabilisierten, wenig verzweigten Partikel dichte Schichten ausbildbar sind. Mizushima et al. [5] und Tadanaga et al. [6] untersuchten außerdem die Hydrolyse und Struktur von mit Ethylacetoacetat modifizierten ASB-Gelen. Mit Ethylacetoacetat modifizierte Gele zeigen unter bestimmten Bedingungen eine Langzeitstabilität von >1000 h, jedoch bei etwas höherem Wassergehalt eine sehr geringe Stabilität von zum Teil <1 h, weshalb man sie unter Standardbedingungen als mäßig stabil einstufen kann. Da alkoholische Sole jedoch nur mäßige Beschichtungseigenschaften besitzen sind Sole mit Glykolethern als Lösungsmitteln zu bevorzugen. Bahlawane [8] beschreibt zum Beispiel die Synthese eines Aluminiumoxid Sols in Diethylenglykolmonoethylether jedoch unter Wasser-freien Bedingungen da es sonst vermutlich zur Niederschlagsbildung kommt. Die Stabilität unter Raumbedingungen (Luftfeuchtigkeit) lässt sich vermutlich durch das relativ hydrophobe Medium erklären. [4 - 8]
[4] V. Gonzales-Pena, C. Marquez-Alvarez, I. Diaz, M. Grande, T. Blasco, J. Perez-Pariente, Microporous and Mesoporous Materials 80 (2005) 173-182
[5] Y. Mizushima, M. Hori, M. Saski Journal of Material Research, 8 (1993), 2109-2111
[6] K. Tadanaga, S. Ito, T. Minami, N. Tohge, Journal of Sol-Gel Science and Technology, 3 (1994), 5-10
[7] K. Tadanaga, S. Ito, T. Minami, N. Tohge, Journal of Non-Crystalline Solids, 201 (1996), 231-236
[8] N. Bahlawane, Thin Solid Films, 396 (2001), 126-130

Die vorher genannten und erwünschten Eigenschaften sind auch für sogenannte Hybridsole gültig. Unter Hybridsolen versteht man Sole, welche aus unterschiedlichen Precursoren aufgebaut sind und zur Netzwerkbildung führen können. Im Regelfall werden auch hier Alkoxide verwendet, wie auch in den Beispielen gezeigt. Geeignet sind aber alle Aluminiumorganischen Verbindungen, bzw. wenn Beschichtungen aus Mischungen von verschiedenen Metalloxiden hergestellt werden sollen, entsprechende metallorganische Verbindungen, die sich in Gegenwart von Wasser unter sauren Bedingungen zu den entsprechenden Metalloxiden umsetzen lassen, insbesondere bei einem pH-Wert im Bereich von 4 - 5. Als Hybridmaterialien kommen binäre Mischungen in Frage, bestehend aus Al₂O₃ und den Oxiden, Hydroxiden und Alkoxiden von beispielweise Bor, Gallium, Silicium, Germanium, Zink, Zinn, Phosphor, Titan, Zirkonium, Yttrium, Nickel, Cobalt, Eisen, Cer, Niob, Arsen, Blei und weiteren. Für diese gelten auch die limitierenden Eigenschaften der Ausbildung einer dichten, kompakten Schicht auf Basis von langzeitstabilen, nicht ionisch stabilisierten Schichten. Darüber hinaus sind Hybridsole auf Basis ternärer und quaternärer Mischungen der Oxide und Alkoxide der oben erwähnten Elemente möglich [9 und 10].
[9] F. Babonneau, L. Coury, J. Livage, Journal of Non-Crystalline Solids, 121 (1990), 153-157
[10] G. Zhao, N. Tohge, Materials Research Bulletin, 33 (1998), 21-30

Weitere Synthesen von Al₂O₃-Tinten auf der Basis von Sol-Gel-Reaktionen umfassen wasserfreie Medien, in denen eine längere Lagerzeit nur unter kontrollierten Bedingungen möglich ist, die jedoch für eine gleichmäßige Hydrolyse in Gegenwart von Luftfeuchtigkeit, die für die Bildung homogener Schichten benötigt wird, eher ungeeignet sind und apptikationstechnisch schwierig durchzuführen ist.

Des Weiteren kommen noch Hydrothermal Synthesen von Aluminiumoxid-Hybridmaterialien in Frage, bei denen jedoch keine Tinte entsteht, die zur Beschichtung geeignet ist.

### Aufgabenstellung

Trotz der vielfältigen Anwendungsmöglichkeiten von SiO₂-Schichten und der unterschiedlichen Möglichkeiten die Eigenschaften solcher Schichten zu variieren, ist es wünschenswert, alternative Beschichtungen mit vergleichbaren Eigenschaften zur Verfügung stellen zu können, welche zu neuen und verbesserten Eigenschaften der beschichteten Oberflächen führen. Es ist somit Aufgabe der vorliegenden Erfindung sowohl ein Verfahren zur Herstellung solcher alternativen Schichten zur Verfügung zu stellen, als auch die Verwendung solcher neuen Zusammensetzungen zur Herstellung dünner Barriereschichten bzw. Diffusionsschichten zu ermöglichen.

Durch Versuche und Untersuchung der Eigenschaften wurde gefunden, dass Al₂O₃ in ähnlicher Weise verwendet und in dünnen Schichten auf Oberflächen aufgebracht werden kann wie SiO₂. Durch diese Versuche wurde auch gefunden, dass die Verwendung von Al₂O₃ ein vielversprechender Ersatz für SiO₂-Schichte darstellt. Neben den oben genannten Eignungen entweder als Diffusionsbarriere und/oder als Sol-Gel-basierte Dotierquelle eignet sich Al₂O₃ aufgrund der Härte seiner kristallinen Modifikationen auch für den Einsatz als mechanische Schutzschicht.

Es ist somit auch Aufgabe der vorliegenden Erfindung, ein stabilisiertes, druckbares Aluminiumoxid-Sol zu entwickeln unter Verzicht auf einerseits stabilisierende, jedoch im Hinblick auf die Anwendbarkeit störende, stark korrodierend wirkende Anionen, wie beispielsweise Chlorid und Nitrat, jedoch bei gleichzeitigem Erhalt der Langzeitstabilität des Sols.

Weiterhin ist es Aufgabe der Erfindung ein entsprechendes Aluminium-Sol zu entwickeln, das auf der Oberfläche von Siliciumwafern eine dichte, d. h. diffusionsdichte oder -beständige glatte, nicht poröse Schichten ausbildet.

### Gegenstand der Erfindung

Die Lösung Aufgabe erfolgt durch die Verwendung druckbarer, sterisch stabilisierter Tinten zur Ausbildung von Al₂O₃-Beschichtungen oder von gemischten Al₂O₃-Hybrid-Schichten. Erfindungsgemäße Tinten können aus Precursoren zur Bildung von Al₂O₃ und von einem oder mehreren Oxiden der Elemente, ausgewählt aus der Gruppe der Bor-, Gallium-, Silicium-, Germanium-, Zink-, Zinn-, Phosphor-, Titan-, Zirkonium-, Yttrium-, Nickel-, Cobalt-, Eisen-, Cer-, Niob-, Arsen- und Blei-Oxide, bestehen, wobei die Tinten durch Einbringen entsprechender Precursoren erhalten werden. Bevorzugt werden sterisch stabilisierte Tinten verwendet, die durch Vermischen mit mindestens einer hydrophoben Komponente und mindestens einer hydrophilen Komponente, sowie gegebenenfalls mit mindestens einem Chelatbildner, erhalten werden. Weiterhin enthalten diese Tinten vorzugsweise mindestens eine hydrophobe Komponente, ausgewählt aus der Gruppe 1,3-Cyclohexadion, Salicylsäure und strukturverwandten Verbindungen und mindestens eine mäßig hydrophilen Verbindung ausgewählt aus der Gruppe Acetylaceton, Dihydroxybenzoesäure und Trihydroxybenzoesäure oder deren strukturverwandte Verbindungen, Chelatbildner wie Ethylendiamintetraessigsäure (EDTA), Diethylentriaminpeantaessigsäure (DETPA), Nitrilotriessigsäure (NTA), Ethylendiaminetetramethylenephosphonsäure (EDTPA) und Diethylentriaminpentamethylenephosphonsäure (DETPPA) oder strukturverwandter Komplexbildner oder entsprechender Chelatbildner. Neben diesen Komponenten enthalten die verwendeten Tinten Lösungsmittel, ausgewählt aus der Gruppe der niedrig siedenden Alkohole, bevorzugt ausgewählt aus der Gruppe Ethanol und Isopropanol, und mindestens einen hochsiedenden Alkohol, ausgewählt aus der Gruppe der hochsiedenden Glykolether, bevorzugt ausgewählt aus der Gruppe Diethylenglykolmonoethylether, Ethylenglykolmonobutylether und Diethylenglykolmonobutylether oder deren Mischungen, sowie gegebenenfalls polare Lösungsmittel ausgewählt aus der Gruppe Aceton, DMSO, Sulfolan und Ethylacetat oder ähnliche polare Lösungsmittel. Besonders vorteilhaft ist die erfindungsgemäße Verwendung von entsprechenden Tinten, welche einen sauren pH-Wert im Bereich von 4 - 5, vorzugsweise kleiner 4,5, aufweisen und als Säuren eine oder mehrere organische Säuren enthalten, die zu einer rückstandsfreien Trocknung führen. Besonders bevorzugt ist die Verwendung dieser Tinten zur Ausbildung von dichten, homogenen Schichten, denen zur Hydrolyse Wasser im molaren Verhältnis von Wasser zu Precursor im Bereich von 1 : 1 bis 1 : 9 , bevorzugt zwischen 1 : 1,5 und 1 : 2,5 zugegeben wird, wobei der Feststoffgehalt im Bereich 0,5 bis 10 Gew.-%, bevorzugt im Bereich zwischen 1 und 6 Gew.-% liegt. Insbesondere lassen sich diese Tinten verwenden zur Herstellung von Diffusionsbarrieren, gedruckten Dielektrika, von elektronischen und elektrischen Passivierungen, Antireflexbeschichtungen, von mechanischen Schutzschichten gegen Verschleiß, oder von chemischen Schutzschichten gegen Oxidation oder Säureeinwirkung. Andererseits sind diese Tinten vorteilhaft zur Verwendung zur Herstellung von Hybridmaterialien mit einfachen und polymeren Bor- und Phosphoroxiden sowie deren Alkoxiden geeignet, die zur arealen und lokalen Dotierung von Halbleitern, vorzugsweise von Silicium geeignet, oder von Al₂O₃-Schichten, welche als Natrium und Kalium Diffusionsbarrieren in der LCD Technik wirken. Werden die erfindungsgemäßen Al₂O₃-Tinten zur Herstellung von Bor-dotierten Schichten eingesetzt, wird die Zusammensetzung der Sol-Gel-Zusammensetzung so eingestellt, dass Hybridschichten mit einem Bortrioxidgehalt im Bereich von 5 - 55 mol-%, bevorzugt im Bereich von 20-45 mol-% erhalten werden.

Gegenstand der vorliegenden Erfindung ist insbesondere auch ein Verfahren zur Herstellung von reinen rückstandsfreien amorphen Al₂O₃-Schichten auf mono- oder multikristallinen Siliziumwafern, Saphirwafern, Dünnschichtsolarmodulen, mit funktionalen Materialien (z.B. ITO, FTO, AZO, IZO oder vergleichbare) beschichteten Gläsern, unbeschichteten Gläsern, Stahlelementen und Legierungen, sowie auf sonstigen in der Mikroelektronik verwendete Materialien, worin nach dem Auftragen einer dünnen Schicht der erfindungsgemäßen Tinte, die Trocknung bei Temperaturen zwischen 300 und 1000 °C, bevorzugt bei 300 bis 450 °C, erfolgt. Die Oberfläche, auf die die Sol-Gel-Tinte aufgetragen wird, kann hydrophob oder hydrophil terminiert vorliegen und wird vor dem Auftrag der Tinte gereinigt, vorzugsweise durch Ätzen mit HF-Lösung oder durch einfaches Waschen mit Wasser (rinsing).

Durch Trocknen und Tempern der aufgetragenen Tinten bei Temperaturen ab 1000 °C werden nicht mehr nur amorphe Schichten erhalten, sondern es werden harte, kristalline Schichten mit vergleichbaren Eigenschaften wie Korund ausgebildet.

Durch Auftragen einer geeigneten Menge Tinte wird innerhalb einer Trocknungszeit von wenigen Minuten, vorzugsweise innerhalb von weniger als 5 Minuten, eine Al₂O₃-Schicht einer Schichtdicke im bereich von 20 bis 300 nm, vorzugsweise von weniger als 100 nm ausbildet, welche Oberflächen passivierend wirkt. Vorzugsweise können nach dem erfindungsgemäßen Verfahren reine, rückstandsfreie, amorphe strukturierbare Al₂O₃-Schichten hergestellt werden, wenn die Trocknung nach dem Auftragen einer dünnen Schicht Tinte bei Temperaturen im Bereich von 300 °C und 550 °C, vorzugsweise bei Temperaturen i9m Bereich von 350 bis 500°C erfolgt. Entsprechende, mittels strukturiert auftragbarer Tinten, hergestellte Schichten können durch die Verwendung der meisten anorganischen Mineralsäuren, bevorzugt jedoch durch HF und H₃PO₄, sowie durch viele organische Säuren, wie Essigsäure, Propionsäure und ähnliche geätzt und nachstrukturiert werden.

Durch den erfindungsgemäßen Sol-Gel-Prozess bilden sich bei Temperaturen unter 400 °C in einer kombinierten Trocknungs- und Temperungsbehandlung stabile und glatte Schichten aus, die frei sind von organischen Kontaminaten.

### Detaillierte Beschreibung der Erfindung

Erfindungsgemäß sterisch stabilisierte Al₂O₃-Tinten mit einem sauren pH-Wert im Bereich von 4 - 5, vorzugsweise kleiner 4,5, auf Basis alkoholischer und polyoxylierter Lösungsmittel mit sehr guten Benetzungs- und Adhäsionseigenschaften auf SiO₂ und silan-terminierten Siliciumwaferoberflächen sind vorteilhafter Weise einsetzbar zur Ausbildung von homogenen, dichten, d. h. diffusionsdichten Schichten.

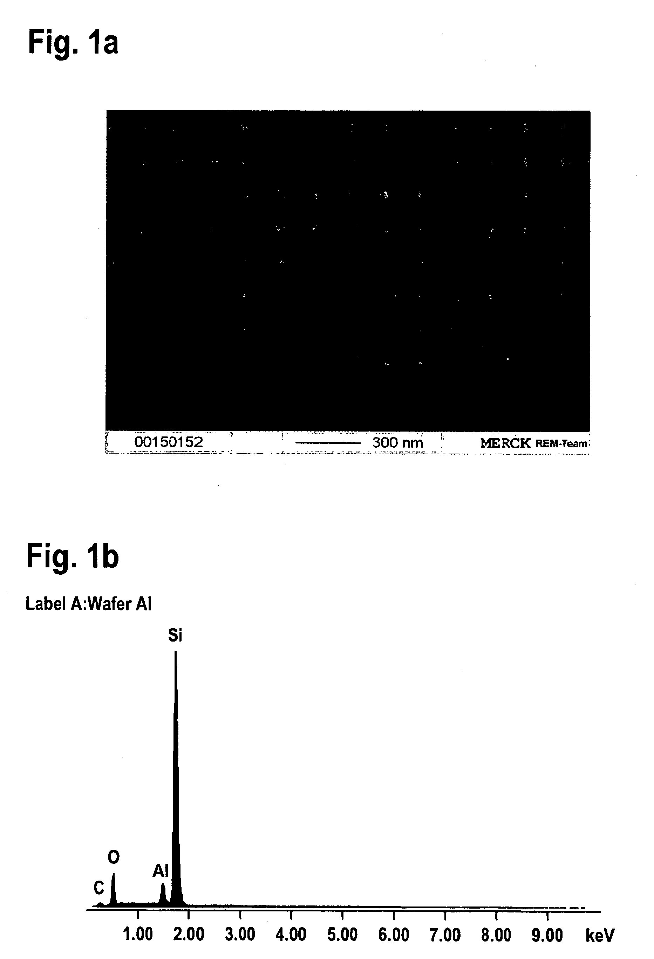

Eine solche Schicht ist in Fig. 1 a und 1 b gezeigt in Form einer rasterelektronenmikroskopische Aufnahme einer erfindungsgemäß hergestellten Al₂O₃ Schicht auf einem polierten (100) Siliziumwafer und der dazugehörigen EDX-Analyse.

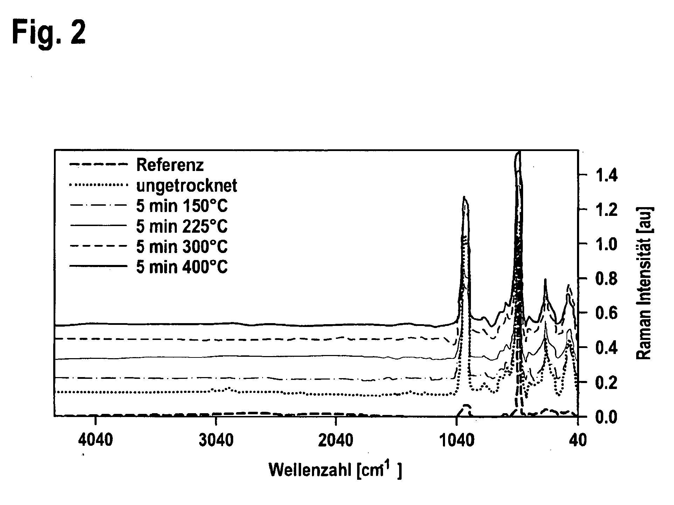

Erfolgt im erfindungsgemäßen Verfahren die Trocknung oberhalb von 300°C, bildet sich eine amorphe Al₂O₃-Schicht, die frei ist von organischen Verunreinigungen. Dies konnte durch Ramanspektroskopie nachgewiesen werden. In Fig. 2 ist eine temperaturabhängige Ramananalyse einer resultierenden Al₂O₃ Schicht auf einem polierten (100) Siliciumwafer dargestellt.

Zur Formulierung des erfindungsgemäß als Tinte eingesetzten Aluminium-Sols können entsprechende Alkoxide des Aluminiums verwendet werden. Dieses können Aluminiumtriethylat, Aluminiumtriisopropylat und Aluminiumtrisec-butylat sein. Alternativ können zu diesem Zweck auch leicht lösliche Hydroxide und Oxide des Aluminiums benutzt werden.

Die Alkoxide werden in einer geeigneten Lösungsmittelmischung gelöst. Diese Lösungmittelmischung kann sich sowohl aus polaren protischen, als auch polaren aprotischen Lösungsmitteln und deren Mischungen zusammensetzen. Ergänzend und gemäß der vorgegebenen Anwendungsbedingungen können die Lösungsmittelgemische durch das Zusetzen von unpolaren Lösungsmitteln, beispielsweise hinsichtlich ihres Benetzungsverhaltens in weiten Grenzen den gewünschten Bedingungen und Eigenschaften der Beschichtungen angepasst werden. Geeignete polare protische Lösungsmittel können sein:
- Aliphatische gesättigte und ungesättigte ein- bis mehrwertige funktionalisierte und unfunktionalisierte Alkohole
   ∘ wie Methanol, Ethanol, Propanol, Butanol, Amylalkohol, Propargylalkohol und Homologe mit bis zu 10 C-Atomen (C ≤ 10)
   ∘ wie beliebig verzweigte, alkylierte, sekundäre und tertiäre Alkohole, wie beispielsweise Isopropanol, 2-Butanol, Isobutanol, tert-Butanol und deren Homologe, vorzugsweise Isopropanol und 2-Butanol
   ∘ wie Glykol, Pinakole, 1,2-Propandiol, 1,3-Propandiol, 1,2,3-Propantriol, und weitere verzweigte Homologe
   ∘ wie Monoethanolamin, Diethanolamin und Triethanolamin
- Glykolether und kondensierte Glykolether sowie Propylenglykolether und kondensierte Propylenglykolether und deren verzweigte Homologe
   ∘ wie Methoxyethanol, Ethoxyethanol, Propoxyethanol, Butoxyethanol, Pentoxyethanol, Phenoxyethanol und weitere
   ∘ Diethylenglykol, Diethylenglykolmonomethylether, Diethylenglykolmonoethylether, Diethylenglykolmonopropylether, Diethylenglykolmonobutylether, Diethylenglykolmonopentylether, Diethylenglykoldimethylether, Diethylenglykoldiethylether, Diethylenglykoldipropylether, Diethylenglykoldibutylether, Diethylenglykoldipentylether und weitere, ,
   o Propyleneglykol, Methoxy-2-propanol, Propylenglykolmonomethylether, Propylenglykoldimethylether, Propylenglykolmonoethylether, Propylenglykoldiethylether, Phenoxypropylenglykol und weitere.

Geeignete polare aprotische Lösungsmittel können sein:
- Dimethylsulfoxid, Sulfolan, 1,4-Dioxan, 1,3-Dioxan, Aceton, Acetylaceton, Dimethylformamid, Dimethylacetamid, Ethylmethylketon, Diethylketon und weitere.

Die Synthese des Sols erfordert bei Verwendung von Aluminiumalkoxiden weiterhin die Zugabe von Wasser zur Erzielung der Hydrolyse der Aluminiumkerne und deren einsetzender Präkondensation. Die Zugabe des benötigten Wassers kann unter- bis überstöchiometrisch erfolgen. Vorzugsweise erfolgt ein unterstöchiometrischer Zusatz.

Die bei der Hydrolyse der Aluminiumkerne freigesetzten Alkoxide werden durch Zugabe einer organischen Säure und/oder Mischungen organischer Säuren zu den korrespondierenden Alkoholen umgesetzt. Die Zugabe der Säure bzw. der Säuremischungen erfolgt dergestalt, dass ein pH-Wert im Bereich von 4 - 5, vorzugsweise kleiner 4,5, erzielt werden kann. Die zugesetzte Säure und/oder Säuremischungen agieren darüber hinaus als Katalysator für die Präkondensation und die damit einsetzende Vernetzung der in der Lösung hydrolysierten Aluminiumkerne.
Als geeignete organische Säuren können hierfür dienen:
∘ Ameisensäure, Essigsäure, Acetessigsäure, Trifluoressigsäure, Monochlor- bis Trichloressigsäure, Phenoxyessigäure, Glykolsäure, Brenztraubensäure, Glyoxylsäure, Oxalsäure, Propionsäure, Chlorpropionsäure, Milchsäure, β-Hydroxypropionsäure, Glycerinsäure, Valeriansäure, Trimethylessigsäure, Acrylsäure, Methacrylsäure, Vinylessigsäure, Crotonsäure, Isocrotonsäure, Glycin und weitere α-Aminosäuren, β-Alanin, Malonsäure, Bernsteinsäure, Malein- und Fumarsäure, Äpfelsäure, Tartronsäure, Mesoxalsäure, Acetylendicarbonsäure, Weinsäure, Citronensäure, Oxalessigsäure, Benzoesäure, alkylierte und halogenierte, nitrierte und hydrolyxierte Benzoesäuren, wie Salicylsäure, und weitere Homologe,

Die Stabilisierung des Aluminium-Sols kann entweder durch die oben genannten organischen Säuren und/oder deren Mischungen erfolgen, oder aber durch die gezielte Zugabe von komplexbildenden und/oder chelatisierenden Additiven erreicht werden bzw. durch deren Zugabe kann die Stabilität des Aluminium-Sols erhöht werden. Als Komplexbildner für Aluminium können die folgenden Substanzen Anwendung finden:
- Nitrilotriessigsäure, Nitrilotris(methylenphosphonsäure).
   Ethylendiamintetraessigsäure,
   Ethylendiamintetrakis(methylenphosphonsäure),
   Diethylenglykoldiamintetraessigsäure, Diethylentriaminpentaessigsäure,
   Diethylenglykoltriamintetrakis(methylenphosphonsäure),
   Diethylentetraminpentakis(methylenphosphonsäure),
   Triethylentetraminhexaessigsäure,
   Triethylentetraminhexakis(methylenphosphonsäure),
   Cyclohexandiamintetraessigsäure,
   Cylcohexandiamintetrakis(methylenphosphonsäure), Etidronic Acid,
   Iminodiessigsäure, Iminobis(methylenphosphonsäure),
   Hexamethylendiamintetrakis(methylenphosphonsäure), MIDA, MIDAPO, Hydroxyethyliminodiessigsäure,
   Hydroxyethylethylendiamintetraessigsäure,
   Trimethylendinitrilotetraessigsäure, 2-Hydroxytrimethylendinitrilotetraessigsäure, Maltol, Ethylmaltol, Isomaltol, Kojisäure, Mimosin, Mimosinsäure, Mimosinmethylether, 1,2-Dimethyl-3-hydroxy-4-pyridinon, 1,2-Diethyl-3-hydroxy-4-pyridinon, 1-Methyl-3-hydroxy-4-pyridinon, 1-Ethyl-2-methyl-3-hydroxy-4-pyridinon, 1-Methyl-2-ethyl-3-hydroxy-4-pyridinon, 1-Propyl-3-hydroxy-4-pyridinon, 3-Hydroxy-2-pyridinone, 3-Hydroxy-1-pyridinthione, 3-Hydroxy-2-pyridinthione, Milchsäure, Maleinsäure, D-Gluconsäure, Weinsäure, 8-Hydroxychinolin, Catechol, 1,8-Dihydroxynaphthalin, 2,6-Dihydroxynaphthalin, Naphthalsäure (Naphthalin-1,8-dicarbonsäure), 3,4-Dihydroxynaphthalin, 2-Hydroxy-1-naphthoesäure, 2-Hydroxy-3-naphthoesäure, Dopamin, L-Dopa, Desferal bzw. Desferriferrioxamin-B, Acetonhydroxamsäure, 1-Propyl- und 1-Butyl- und 1-Hexyl-2-methyl-3-hydroxy-4-pyridinon, 1-Phenyl- und 1-p-Tolyl- und 1-p-Methoxyphenyl und 1-p-Nitrophenyl-2-methyl-3-hydroxy-4-pyridinon, 2-(2'-Hydroxyphenyl)-2-oxazolin, 2-(2'-Hydroxyphenyl)-2-benzoxazol, 2,X-Dihydroxybenzoesäure (mit X = 3, 4, 5, 6), sonstige alkylierte, halogenierte, nitrierte 2,X-Dihydroxybenzoesäuren, Salicylsäure und deren alkylierte, halogenierte und nitrierte Derivate, wie 4-Nitro- und 5-Nitrosalicysäure, 3,4-Dihydroxybenzoesäure, sonstige alkylierte, halogenierte, nitrierte 3,4-Dihydroxybenzoesäuren, 2,3,4-Trihydoxybenzoesäure, sonstige alkylierte, halogenierte, nitrierte 2,3,4-Trihydroxybenzoesäuren, 2,3-Dihydroxyterephthalsäure, sonstige alkylierte, halogenierte, nitrierte 2,3-Dihydroxyterephthalsäuren, Mono-, Di- und Trihydroxyphthalsäuren, sowie deren sonstige alkylierte, halogenierte, nitrierte Derivate, 2-(3', 4'-Dihydroxyphenyl)-3,4-dihydro-2H-1-benzopyran-3,5,7-triol (Komponente aus Tannin), Malonsäure, Oxydiessigsäure, Oxalessigsäure, Tartronsäure, Äpfelsäure, Bernsteinsäure, Hippursäure, Glykolsäure, Citronensäure, Weinsäure, Acetessigsäure, Ethanolamine, Glycin, Alanin, β-Alanin, Alaninhydroxamsäure, α-Aminohydroxamsäuren, Rhodotorulsäure, 1,1',1"-Nitrilo-2-propanol, N,N-Bis(2-hydroxyethyl)-glycin, Bis-(2-hydroxyethyl)-iminotris-(hydroxymethyl)-methan, N-(Tris(hydroxymethyl)-methyl)-glycin, Ethylendiamintetra-2-propanol, N,N-Bis(2-hydroxyethyl)-2-aminoethansulfonsäure, N-(Tris(hydroxymethyl)-methyl)-2-aminoethansulfonsäure, Pentaerythrit, N-Butyl-2,2'-iminodiethanol, Monoethanolamin, Diethanolamin, Triethanolamin, Acetylaceton, 1,3-Cyclohexandion, und weitere substituierte (bzw. alkylierte, halogenierte, nitrierte, sulphonierte, carboxylierte) Homologe und Derivate der oben genannten Komplex- und Chelatbildner, sowie deren Salze, vorzugsweise Ammoniumsalze, sowie
- weitere Komplex- und Chelatbildner, welche Al koordinieren können.

Des Weiteren können dem Aluminium-Sol zwecks gezielter Einstellung der erwünschter Eigenschaften, welche beispielsweise eine vorteilhafte Oberflächenspannung, Viskosität oder ein verbessertes Benetzungs- und, Trocknungsverhalten und eine verbesserte Adhäsion sein können, weitere Additive zugesetzt werden.
Solche Additive können sein:
- Tenside, tensioaktive Verbindungen zur Beeinflussung der Benetzungs- und Trocknungsverhaltens,
- Entschäumer und Entlüfter zur Beeinflussung des Trocknungsverhaltens,
- weitere hoch und niedrig siedende polare protische und aprotische Lösungsmittel zur Beeinflussung der Partikelgrößenverteilung, des Präkondensationgrades, Kondensations-, Benetzungs- und Trocknungssowie Druckverhaltens,
- weitere hoch und niedrig siedende unpolare Lösungsmittel zur Beeinflussung der Partikelgrößenverteilung, des Präkondensationgrades, Kondensations-, Benetzungs- und Trocknungssowie Druckverhaltens,
- Polymere zur Beeinflussung der rheologischen Eigenschaften (Strukturviskositäten, Thixotropien, Fließgrenzen etc.),
- partikuläre Zuschlagsstoffe zur Beeinflussung der rheologischen Eigenschaften,
- partikuläre Zuschlagsstoffe (z. B. Aluminiumhydroxide und Aluminiumoxide, Siliciumdioxid) zur Beeinflussung der nach Trocknung resultierenden Trockenfilmdicken sowie deren Morphologie,
- partikuläre Zuschlagsstoffe (z. B. Aluminiumhydroxide und Aluminiumoxide, Siliciumdioxid) zur Beeinflussung der Kratzbeständigkeit der getrockneten Filme,
- Oxide, Hydroxide, basische Oxide, Alkoxide, präkondensierte Alkoxide von Bor, Gallium, Silicium, Germanium, Zink, Zinn, Phosphor, Titan, Zirkonium, Yttrium, Nickel, Kobalt, Eisen, Cer, Niob, Arsen, Blei und Weiteren zur Formulierung von Hybridsolen,
- insbesondere einfache und polymere Oxide, Hydroxide, Alkoxide von Bor und Phosphor zur Formulierung von auf Halbleiter, insbesondere Silicium, dotierend wirkende Formulierungen,

Vorteilhafter Weise ist das Aluminium-Sol druckbar und lässt sich mittels verschiedener Druckverfahren auf Oberflächen, vorzugsweise Siliciumwaferoberflächen, aufbringen. Solche Druckverfahren können namentlich folgende sein:
- Spin oder Dip Coating, Drop Casting, Curtain oder Slot-dye Coating, Screen oder Flexo Printing, Gravure oder Ink Jet oder Aerosol Jet Printing, Offset Printing, Micro Contact Printing, Electrohydrodynamic Dispensing, Roller oder Spray Coating, Ultrasonic Spray Coating, Pipe Jetting, Laser Transfer Printing, Pad Printing, Rotationssiebdruck und weitere.
   Diese Aufzählung ist nicht als abschließend zu betrachten und es sind darüber hinaus weitere Methoden zum Drucken oder selektiven Aufbringen der erfindungsgemäßen Tinten möglich.

In diesem Zusammenhang versteht es sich von selbst, dass jede Druck- und Beschichtungsmethode ihre eigenen Anforderungen an die zu verdruckende Tinte und/oder aus der Tinte resultierende Paste stellt. Typischerweise sind für die jeweilige Druckmethode individuell bestimmte Parameter einzustellend, beispielsweise die Oberflächenspannung, die Viskosität und der Gesamtdampfdruck der Tinte, der sich aus der Zusammensetzung der Paste ergibt.

Die druckbaren Tinten und Pasten können neben deren Anwendung als Kratzschutz- und Korrosionschutzschichten, wie z. B. in der Herstellung von Bauteilen in der Metallindustrie, vorzugsweise in der Elektronikindustrie, und hierbei insbesondere in der Fertigung mikroelektronischer, photovoltaischer und mikroelektromechanischer (MEMS) Bauteile, Anwendung finden. Unter photovoltaischen Bauteilen sind in diesem Zusammenhang insbesondere Solarzellen und -module zu verstehen. Weiterhin sind Anwendungen in der Elektronikindustrie möglich, indem die beschriebenen Tinten und Pasten in den folgenden, beispielhaft genannten, jedoch nicht umfassend aufgezählten Gebieten verwendet werden:
Fertigung von Dünnschicht-Solarzellen aus Dünnschicht-Solarmodulen,
Herstellung organischer Solarzellen,
Herstellung gedruckter Schaltungen und organischer Elektronik,
Herstellung Anzeigeelementen auf Basis der Technologien von Dünnfilmtransistoren (TFT), Flüssigkristallen (LCD), organische lichtemittierende Dioden (OLED) und berührungsempfindlichen kapazitiven und resistiven Sensoren.

Die vorliegende Erfindung besteht somit insbesondere auch in der Bereitstellung von druckbaren, sterisch stabilisierten Tinten zur Ausbildung von Al₂O₃-Beschichtungen sowie von gemischten Al₂O₃-Hybrid-Schichten.

Als Hybridmaterialien kommen Mischungen von Al₂O₃ mit Oxiden der Elemente Bor, Gallium, Silicium, Germanium, Zink, Zinn, Phosphor, Titan, Zirkonium, Yttrium, Nickel, Cobalt, Eisen, Cer, Niob, Arsen und Blei in Frage, wobei die Tinten durch Einbringung der entsprechenden Precursoren in die Tintenflüssigkeit erhalten werden. Eine sterische Stabilisierung der Tinten erfolgt dabei durch Vermischen mit hydrophoben Komponenten, wie 1,3-Cyclohexadion, Salicylsäure und deren Strukturverwandten, und mäßig hydrophilen Komponenten, wie Acetylaceton, Dihydroxybenzoesäure, Trihydroxybenzoesäure sowie deren Strukturverwandten, oder mit Chelatbildnern, wie Ethylendiamintetraessigsäure (EDTA), Diethylentriaminpeantaessigsäure (DETPA), Nitrilotriessigsäure (NTA), Ethylendiaminetetramethylenephosphonsäure (EDTPA), Diethylentriaminpentamethylenephosphonsäure (DETPPA) und strukturverwandten Komplexbildnern bzw. Chelatbildnern.

Als Lösungsmittel können in den Tinten Mischungen aus mindestens einem niedrigsiedendem Alkohol, vorzugsweise Ethanol oder Isopropanol, und einem hochsiedenden Glykolether, bevorzugt Diethylenglykolmonoethylether, Ethylenglykolmonobutylether oder Diethylenglykolmonobutylether, eingesetzt werden. Es können aber auch andere polare Lösungsmittel, wie Aceton, DMSO, Sulfolan oder Ethylacetat und ähnliche verwendet werden. Durch ihr Mischungsverhältnis kann die Beschichtungseigenschaft der Tinte an das gewünschte Substrat angepasst werden. Durch Hinzufügen von Säuren wird in den Tinten ein saurer pH-Wert eingestellt, vorzugsweise im Bereich von pH 4-5), Zur Einstellung des pH-Werts können als Säure organische Säuren, bevorzugt Essigsäure, verwendet werden, die zu einer rückstandsfreien Trocknung führen.

Zur Ausbildung der gewünschten dichten, homogenen Schicht wird Wasser zur Hydrolyse zugegeben, wobei das molare Verhältnis von Wasser zu Precursor zwischen 1 : 1 und 1 : 9 liegen sollte, bevorzugt zwischen 1: 1,5 und 1 : 2,5.

Zur Herstellung der erfindungsgemäßen Tinten werden die schichtbildenden Komponenten im Verhältnis so eingesetzt, dass der Feststoffgehalt der Tinten zwischen 0,5 Gew.-% und 10 Gew.-%, bevorzugt zwischen 1 Gew.-% und 6 Gew.-%, liegt.

Durch geeignete Formulierung der Zusammensetzungen werden Tinten erhalten mit einer Lagerstabilität > 3 Monate, wobei innerhalb dieser Zeit keine nachweisbaren Änderungen der Tinten in Bezug auf Viskosität, Partikelgröße oder dem Beschichtungsverhalten nachweisbar sind.

Durch die rückstandsfreie Trocknung der Tinten nach Beschichtung der Oberflächen resultieren amorphe Al₂O₃ Schichten, wobei die Trocknung bei Temperaturen im Bereich von 300 bis 1000 °C, bevorzugt in einem Temperaturbereich von 350 bis 450 °C, erfolgt. Bei geeigneter Beschichtung erfolgt die Trocknung innerhalb einer Zeit von weniger als 5 Minuten, wobei bevorzugt eine Schichtdicke von < 100 nm erhalten wird. Zur Herstellung dickerer Schichten müssen bei Auftragung dickerer Schichten die Trocknungsbedingungen entsprechend variiert werden. Erfolgt die Trocknung bei hohen Temperaturen unter sogenannten Temperungsbedingungen oberhalb von 1000 °C, entstehen harte, kristalline Schichten, die in ihrer Struktur dem Korund vergleichbar sind. Bei Temperaturen unterhalb von 500 °C entstehe getrocknete Al₂O₃(-Hybrid)-Schichten, die durch Verwendung der meisten anorganischen Mineralsäuren, bevorzugt jedoch durch HF und H₃PO₄, sowie durch viele organische Säuren wie Essigsäure, Propionsäure und ähnliche, geätzt werden können. Dadurch ist eine einfache Nachstrukturierung der erhaltenen Schichten möglich. Als Substrat für die Beschichtung mit den erfindungsgemäßen Tinten kommen mono- oder multikristalline Siliziumwafer in Frage, insbesondere HF oder RCA-gereinigte Wafer, oder auch Saphirwafer oder, Dünnschichtsolarmodule mit funktionalen Materialien, wie z.B. mit ITO, FTO, AZO, IZO oder vergleichbaren Materialien beschichtete Gläser, unbeschichtete Gläser, Stahlelemente und Legierungen vor allem im Automobilbereich, sowie sonstige in der Mikroelektronik verwendete Materialien. Entsprechend der verwendeten Substrate können die durch Verwendung der Tinten gebildeten Schichten als Diffusionsbarriere, druckbares Dielektrikum, elektronische und elektrische Passivierung, Antireflexbeschichtung, mechanische Schutzschicht gegen Verschleiß chemische Schutzschicht gegen Oxidation oder Säureeinwirkung dienen.

Die zu diesem Zweck einsetzbaren Sol-Gel-Tinten und/oder -Pasten sind so zu formulieren, dass es sich um druckbare Formulierungen handelt, die, vorzugsweise zu Schichtdicken im Bereich zwischen 20 und 300 nm, besonders bevorzugt zu Schichten mit einer Dicke zwischen 20 und 100 nm, führen, durch die eine hervorragende elektronische Oberflächenpassivierung von halbleitenden Materialien, bevorzugt von Silizium und Siliziumwafern, erzielt wird. Vorteilhafter Weise wird durch die so aufgebrachten und getrockneten, dünnen Al₂O₃-Schichten die Ladungsträgerlebensdauer bereits erhöht. Darüber hinaus wurde gefunden, dass die Oberflächenpassivierung der Schicht noch einmal stark erhöht werden kann, wenn die aufgebrachten Schichten nach dem Trocknen noch für einige Minuten, vorzugsweise bis zu 15 Minuten in einer Stickstoffatmosphäre und/oder Formiergasathmosphäre bei 350 - 550 °C getempert werden.

Hybridmaterialien mit einfachen und polymeren Bor- und Phosphoroxiden, sowie deren Alkoxide auf Basis der erfindungsgemäßen Tinten können zur kostengünstigen arealen und lokalen Dotierung von Halbleitern, vorzugsweise von Silicium, verwendet werden, und zwar in der Elektro- und Elektronikindustrie im Allgemeinen, sowie in der Photovoltaikindustrie im Besonderen, und zwar insbesondere in der Herstellung kristalliner Siliziumsolarzellen und -solarmodule im Speziellen. Erfindungsgemäße Tinten und/oder Pasten sind druckbar und deren Formulierungen und rheologischen Eigenschaften sind in weiten Grenzen den jeweils erforderlichen Bedürfnissen der anzuwendenden Druckmethode anzupassen.

Bei Verwendung von Al₂O₃-B₂O₃ haltigen druckbaren Tinten und/oder Pasten für die Dotierung von Siliciumwafern werden bevorzugt RCA- oder mit einer vergleichbaren Reinigungssequenz gereinigte Siliciumwafer verwendet. Die Waferoberfläche kann vorab hydrophil oder hydrophob eingestellt werden. In bevorzugter Weise erfolgt eine vereinfachte Reinigung der Wafer mittels HF-Lösung und Ätzung. Die nach dem Dotierprozess auf dem Wafer verbleibende Schicht kann mittels Ätzung in verdünnter HF einfach entfernt werden oder strukturiert geätzt werden.

Zur Herstellung von erfindungsgemäßen Bor dotierten Aluminiumoxidbeschichtungen, d. h. von Beschichtungen mit lokalen oder ganzflächigen Dotierungen sind Al₂O₃-B₂O₃ haltige druckbare Tinten und/oder Pasten einzusetzen, die in der dotierten Schicht zu einem molaren Anteil an Dibortrioxid im Bereich von 5 - 55 mol%, bevorzugt zu einem Anteil im Bereich von 20 - 45 mol% führen.

So hergestellte Al₂O₃ können als Natrium und Kalium Diffusionsbarriere in der LCD Technik verwendet werden. Hier kann eine dünne Schicht Al₂O₃ auf dem Deckglas des Displays die Diffusion von Ionen aus dem Deckglas in die Flüssigkristalline Phase hinein verhindern, wodurch die Lebensdauer der LCDs extrem erhöht werden kann.

### Abbildungen und Graphiken:

Fig. 1 zeigt eine rasterelektronenmikroskopische Aufnahme einer resultierenden gleichmäßigen Al₂O₃ Schicht auf einem polierten (100) Siliziumwafer.
Fig. 2 zeigt die temperaturabhängige Ramananalysen von gebildeten Al₂O₃-Schichten.
Fig. 3 zeigt eine rasterelektronenmikroskopische Aufnahme einer mit Aluminium-Sol per Ink Jet bedrucktes poliertes (100) Siliciumwaferstück gemäß Beispiel 7 (a) und eine Kurve der dazugehörigen EDX-Analyse (b).
Fig. 4 zeigt eine rasterelektronenmikroskopische Aufnahme eines mit Aluminium-Zirkonium-Sol gemäß Beispiel 8 bedruckten (100) Siliciumwaferstücks (a) und eine Kurve der dazugehörigen EDX-Analyse (b).
Fig. 5 zeigt eine rasterelektronenmikroskopische Aufnahme eines mit Aluminium-Sol per Ink-Jet bedruckten (100) Siliciumwaferbruchstücks gemäß Beispiel 9.
Fig. 6 zeigt ein gemäß Beispiel 10 mit Aluminium-Sol per Ink Jet bedrucktes poliertes (100) Siliciumwaferstück. Das bedruckte Feld setzt sich aus Spuren unterschiedlicher Breite und unterschiedlichen Spurabständen zusammen.
Fig. 7 zeigt das Ergebnis eines gemäß Beispiel 11 mit Aluminium-Sol per Schleuderbeschichtung beschichteten polierten (100) Siliciumwaferbruchstücks.
Fig. 8 zeigt die Auftragung der gemessene Ladungsträgerlebensdauer in Abhängigkeit der Minoritätsladungsträgerdichte dargestellt, und zwar von einer unbeschichteten Probe, sowie von mit Aluminiumoxid gemäß Beispiel 12 beschichteten Proben mit Schichtdicken von 9 und 17 nm.
Fig. 9 zeigt die Ladungsträgerlebensdauer eines unbeschichteten Siliziumwafers (oben (a)) und eines beidseitig mit Aluminiumoxid gemäß Beispiel 13 beschichteten Siliziumwafers (unten (b)). Die Lebensdauer hat sich durch die Beschichtung um den Faktor 100 erhöht.
Fig. 10 zeigt Ladungträgerlebensdauern von n-dotierten Cz-Waferproben von unbeschichtete Probe (gelb, unten), von einer mit Aluminiumoxid gemäß Beispiel 14 beschichteten Probe (magenta, Mitte) und einer chemisch passivierten Probe (blau, oben). Die Lebensdauern betragen in dieser Reihenfolge (Injektionsdichte: 1E+15): 6 µs, ~120 µs und ∼1000 µs.
Fig. 11 zeigt die Ladungträgerlebensdauern von p-dotierten Cz-Waferproben, und zwar von einer unbeschichteten Probe (gelb, unten), einer mit Aluminiumoxid gemäß Beispiel 15 beschichteten Probe (magenta, mitte) und einer chemisch passivierten Probe (blau, oben). Die Lebensdauern betragen in dieser Reihenfolge (Injektionsdichte: 1 E+15): 6 µs, ∼65 µs und ∼300 µs.
Fig. 12 zeigt die aufgetragenen Ladungträgerlebensdauern von p-dotierten FZ-Waferproben, und zwar von einer unbeschichteten Probe (gelb, unten),
einer mit Aluminiumoxid gemäß Beispiel 16 beschichteten Probe (magenta, Mitte) und einer chemisch passivierte Probe (blau, oben). Die Lebensdauern betrugen in dieser Reihenfolge (Injektionsdichte: 1 E+15): 7 µs, ~400 µs und » 1000 µs.
Fig. 13 zeigt ein Diffusionsprofil der Bor-Dotiertinte gemäß Beispiel 17 mit einem relativen Massenanteil von 0,15 (rote Kurve: p- bzw. Bor-Dotierung infolge der Exposition der Waferoberfläche zur getrockneten Tinte, blaue Kurve: n- oder Phosphor-Basisdotierung). Der Schichtwiderstand der Probe beträgt 464 Ω/square.
Fig. 14 zeigt ein Diffusionsprofil der Bor-Dotiertinte gemäß Beispiel 17 mit einem relativen Massenanteil von 0,3 (rote Kurve: p- bzw. Bor-Dotierung infolge der Exposition der Waferoberfläche zur getrockneten Tinte, blaue Kurve: n- oder Phosphor-Basisdotierung) gezeigt. Der Schichtwiderstand der Probe beträgt 321 Ω/square.
Fig. 15 zeigt das Diffusionsprofil der Bor-Dotiertinte gemäß Beispiel 18 (rote Kurve: p- bzw. Bor-Dotierung infolge der Exposition der Waferoberfläche zur getrockneten Tinte, blaue Kurve: n- oder Phosphor-Basisdotierung). Der Schichtwiderstand der Probe beträgt 65 Ω/square.

Die vorliegende Beschreibung ermöglicht es dem Fachmann die Erfindung umfassend anzuwenden. Auch ohne weitere Ausführungen wird daher davon ausgegangen, dass ein Fachmann die obige Beschreibung im weitesten Umfang nutzen kann.

Bei etwaigen Unklarheiten versteht es sich von selbst, die zitierten Veröffentlichungen und Patentliteratur heranzuziehen. Dementsprechend gelten diese Dokumente als Teil der Offenbarung der vorliegenden Beschreibung.

Zum besseren Verständnis und zur Verdeutlichung der Erfindung werden im Folgenden zwei Beispiele gegeben, die im Rahmen des Schutzbereichs der vorliegenden Erfindung liegen. Diese Beispiele dienen auch zur Veranschaulichung möglicher Varianten. Aufgrund der allgemeinen Gültigkeit des beschriebenen Erfindungsprinzips sind die Beispiele jedoch nicht geeignet, den Schutzbereich der vorliegenden Anmeldung nur auf diese zu reduzieren.

Weiterhin versteht es sich für den Fachmann von selbst, dass sich sowohl in den gegebenen Beispielen als auch in der übrigen Beschreibung die in den Zusammensetzungen enthaltenen Komponentenmengen in der Summe immer nur zu 100 Gew. bzw. mol-% bezogen auf die Gesamtzusammensetzung aufaddieren und nicht darüber hinausgehen können, auch wenn sich aus den angegebenen Prozentbereichen höhere Werte ergeben könnten. Sofern nichts anderes angegeben ist, gelten daher %-Angaben als Gew.- oder mol-%, mit Ausnahme von Verhältnissen, die in Volumenangaben wiedergegeben sind.

Die in den Beispielen und der Beschreibung sowie in den Ansprüchen gegebenen Temperaturen gelten immer in °C.

### Beispiele

### Beispiel 1:

In einem 100 mL Rundhalskolben werden 0,6 g Acetylaceton in 50 mL Isopropanol vorgelegt. Zu der Lösung werden 2,5 g Aluminiumtrisekbutylat zugegeben und für 10 Minuten gerührt. Zur Neutralisation des Butylats und der Einstellung des pH Werts der Tinte werden 2,3g Essigsäure zugegeben und erneut für 10 Minuten gerührt. Zur Hydrolyse des partiell geschützten Aluminiumalkoholats werden 1,2 g Wasser zugegeben und die Lösung nach 10 Minuten Rühren zur Alterung stehen gelassen. Nach etwa 3 Stunden trübt sich die Lösung und nach etwa 3 Tagen fällt ein schleimiger Niederschlag aus. Der Niederschlag kann durch Zusatz von 25 mL Wasser gelöst werden. Die resultierende Lösung hat jedoch schlechte Beschichtungseigenschaften sowohl auf HF als auch auf RCA gereinigten Wafern. Durch Zugabe von Tensid zu den auf diese Weise dargestellten Tinten verbessern sich zwar die Benetzungseigenschaften der Tinte, jedoch bilden sich innerhalb der resultierenden Schicht Anhäufungen von Feststoff, die durch micellenartige Stabilisierung der Primärkondensate innerhalb der Tinte zu deuten sind. Dieselben Ergebnisse werden bei Stoffmengenverhältnissen von Aluminium zu Acetylaceton zwischen 0,5 und 3 erhalten, jedoch nimmt die benötigte Wassermenge zur Lösung des Niederschlags ab. Mit Citronensäure, Oxalsäure und Ascorbinsäure werden auch größere Mengen Wasser benötigt um den Niederschlag zu lösen.

### Beispiel 2:

In einem 100 mL Rundhalskolben werden 0,6 g Acetylaceton in 50 mL Methanol vorgelegt. Zu der Lösung werden 2,5 g Aluminiumtrisekbutylat zugegeben und für 10 Minuten gerührt. Zur Neutralisation des Butylats und der Einstellung des pH Werts der Tinte werden 2,3g Essigsäure zugegeben und erneut für 10 Minuten gerührt. Zur Hydrolyse des partiell geschützten Aluminiumalkoholats werden 1,2 g Wasser zugegeben und die Lösung nach 10 Minuten Rühren zur Alterung stehen gelassen. Der Feststoffgehalt kann in der Lösung bis zu 6 Gew.-% erhöht werden, wobei die entsprechenden Mengen an Essigsäure und Acetylaceton einzusetzen sind. Die Lösung ist über Monate stabil, jedoch besitzt Methanol eine zu geringe Viskosität um über variable Druckmethoden applizierbar zu sein. Bei Mischungen von Methanol mit Glykolethern oder Isopropanol tritt innerhalb weniger Tage unter gleichen Bedingungen Niederschlagsbildung ein.

### Beispiel 3:

In einem 100 mL Rundhalskolben werden 0,8 g Salicylsäure in 50 mL Isopropanol vorgelegt. Zu der Lösung werden 2,5 g Aluminium-tri-sek.-butylat zugegeben und für 10 Minuten gerührt. Zur Neutralisation des Butylats und der Einstellung des pH Werts der Tinte werden 2,3 g Essigsäure zugegeben und erneut für 10 Minuten gerührt. Zur Hydrolyse des partiell geschützten Aluminiumalkoholats werden 1,2 g Wasser zugegeben und die Lösung nach 10 Minuten Rühren zur Alterung stehen gelassen. Direkt nach Wasserzugabe bildet sich eine trübe Suspension, aus der sich nur sehr langsam (innerhalb von 20 Tagen) ein Niederschlag absetzt. Der Niederschlag kann nicht durch Zusatz von Wasser gelöst werden.

### Beispiel 4:

In einem 100 mL Rundhalskolben werden 3 g Salicylsäure und 1 g Acetylaceton in 25 mL Isopropanol und 25 mL Diethylenglykolmonoethylether vorgelegt. Zu der Lösung werden 4,9 g Aluminiumtrisekbutylat zugegeben und für 10 Minuten gerührt. Zur Neutralisation des Butylats und der Einstellung des pH Werts der Tinte werden 5 g Essigsäure zugegeben und erneut für 10 Minuten gerührt. Zur Hydrolyse des partiell geschützten Aluminiumalkoholats werden 1,7 g Wasser zugegeben und die leicht gelbe Lösung nach 10 Minuten Rühren zur Alterung stehen gelassen. Der Feststoffgehalt kann auf bis zu 6% erhöht werden. Die Tinte zeigt eine Stabilität von > 3 Monaten bei idealen Beschichtungseigenschaften und effizienter Trocknung (siehe Fig. 1 und 2).

Außerdem können hydridterminierte Wafer (HF-Reinigung) mit dieser Tinte via Spincoating homogen beschichtet werden. Durch Einbringen von Boroxid in diese Tinte können Spin-On-Dopants Schichten erstellt werden, die nach Diffusion bei 1000°C sich durch einen einfachen HF-Dip leicht abätzen lassen. Der Schichtwiderstand nach der Dotierung beträgt 80 Ω/square. Dieser kann durch Adjustierung der Prozessdauer, Tempertemperatur und Borkonzentration in der Tinte variabel eingestellt werden. Als alternative Komplexbildner zu Acetylaceton können Polyhydroxybenzoesäuren verwendet werden.

### Beispiel 5:

In einem 100 mL Rundhalskolben werden 2 g Salicylsäure und 0,8 g Acetylaceton in 30 g Diethylenglykolmonoethylether vorgelegt. Zu der Lösung werden 5,2 g Aluminiumtrisekbutylat und 0,2 g Essigsäure zugegeben und für 10 Minuten gerührt. Zur Hydrolyse des partiell geschützten Aluminiumalkoholats werden nun 1,5 g Wasser zugegeben und die leicht gelbe Lösung nach 10 Minuten rühren zur Alterung stehen gelassen.

Der Feststoffgehalt kann auf bis zu 10% erhöht werden. Die Tinte zeigt trotz des hohem Wassergehalts (n(Wasser)/n(Al)=6,5) eine Stabilität von > 200 Stunden bei 50°C (nach dieser Zeit Abbruch des Versuchs, ohne dass sich ein Niederschlag gebildet hat).

### Anmerkung:

Bei geringeren Wasserkonzentrationen (<0,7 g) können auch stabile Tinten (> 3 Monate) ohne den Zusatz von Essigsäure oder anderen Säuren unter Erhalt der idealen Beschichtungseigenschaften und der effizienten Trocknung (siehe Fig. 1 und 2) synthetisiert werden. Außerdem können Hydrid-terminierte Wafer (HF-Reinigung) mit dieser Tinte via Spincoating homogen beschichtet werden. Als weitere Komplexbildner kommen statt Acetylaceton Polyhydroxybenzoesäure in Frage, wobei durch die Zugabe der Komplexbildner die Viskosität des erhaltenen Sols maßgeblich beeinflusst wird.

### Beispiel 6:

Gemäß Beispiel 5 wird eine Tinte durch Zugabe von Boroxid modifiziert. Durch Einbringen von Boroxid in diese Tinte können Spin-On-Dopants Schichten erstellt werden, die sich nach Diffusion bei >1000°C durch einen einfachen HF-Dip leicht abätzen lassen. Der Schichtwiderstand eines 150 Ω/square n-Typ Wafers, beschichtet mit einer solchen Spin-on-Dopant Schicht, beträgt nach Diffusion bei 1050°C 80 Ω/square, was gut in das Fenster von konventionellen Bor-dotierten Siliziumwafern (50-100 Ω/square) passt.

### Beispiel 7:

Gemäß Beispiel 5 wird ein Titanoxid-Aluminiumoxid Hybridsol hergestellt. Dazu werden die Precursoren Aluminiumtrisekbutylat und Titantetraethanolat in einem molaren Verhältnis von 50/50 bei einem Molverhältnis Precursor zu Komplexbildner von 0,8 in einer wie in Beispiel 5 geschilderten Lösung vorgelegt. Zu der Precursorlösung wird anschließend Wasser zugegeben (Stoffmengenverhältnis Wasser zu Gesamtmenge Precursor: 3:1) und die Lösung über Nacht gerührt.

Durch Aufbringen des erhaltenen Hybridsol auf einen Wafer und Trocknen bei erhöhter Temperatur wird eine einheitliche dichte Aluminiumoxid-TitandioxidSchicht erhalten.

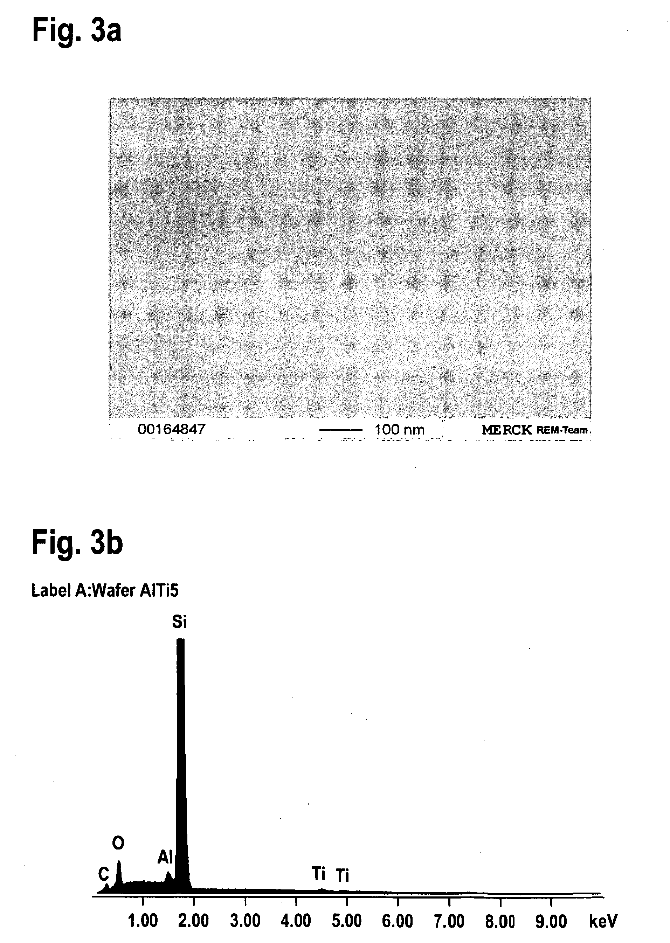

In Fig. 3 ist eine Rasterelektronenmikroskopische Aufnahme sowie eine EDX-Analyse einer nach diesem Beispiel hergestellten Aluminiumoxid-Titandioxid-Schicht gezeigt.

### Beispiel 8:

Gemäß Beispiel 5 wird ein Zirkoniumoxid-Aluminiumoxid Hybridsol hergestellt. Dazu werden die Precursoren Aluminiumtrisekbutylat und Zirkoniumtetraethanolat in einem molaren Verhältnis von 50/50 bei einem molaren Verhältnis Precursor: Komplexbildner von 0,8 in einer wie in Beispiel 5 geschilderten Lösung vorgelegt. Zu der Precursorlösung wird anschließend Wasser zugegeben (Stoffmengenverhältnis Wasser zu Precursor: 3:1) und die Lösung über Nacht gerührt.

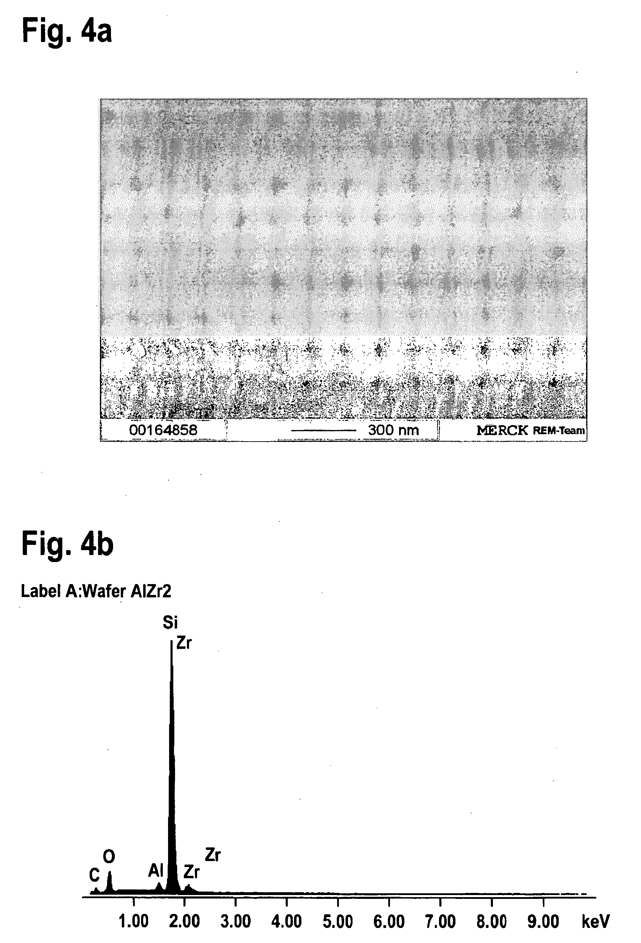

In Fig. 4 ist eine Rasterelektronenmikroskopische Aufnahme sowie EDX-Analyse einer gemäß diesem Beispiel hergestellten Aluminiumoxid-Zirkoniumdioxid Schicht gezeigt.

### Beispiel 9:

Ein poliertes (100) Siliciumwaferstück wird nach RCA-1-Reinigung mittels Ink Jet-Druck mit einer Aluminium-Sol-Tinte gemäß Beispiel 4 bedruckt. Die Temperatur des Substrates beträgt 70 °C und der Tropfenabstand beim Druck beträgt 50 µm. Es wird ein 1 x 1 cm² großes Feld aufgedruckt. Die Schichtdicke der druckfesten Schicht beträgt ~120 nm.

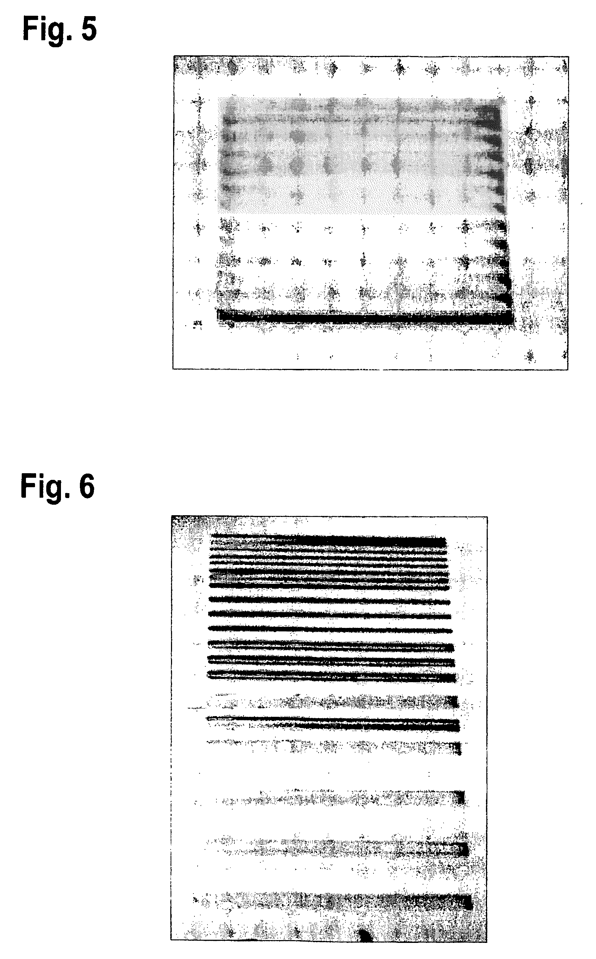

In Fig. 5 ist ein mit Aluminium-Sol per Ink Jet bedrucktes poliertes (100) Siliciumwaferstück, wie hier beschrieben, gezeigt.

### Beispiel 10:

Ein poliertes (100) Siliciumwaferstück wird nach RCA-1-Reinigung mittels Ink Jet-Drucks mit einer Aluminium-Sol-Tinte gemäß Beispiel 4 bedruckt. Die Temperatur des Substrates beträgt 90 °C und der Tropfenabstand beim Druck beträgt 50 µm. Es wird ein 1 x 2 cm² großes Feld, enthaltend Spuren unterschiedlicher Breite und unterschiedlicher Abstände, aufgedruckt.

In Fig. 6 wird ein mit Aluminium-Sol per Ink Jet bedrucktes poliertes (100) Siliciumwaferstück gezeigt. Das bedruckte Feld setzt sich aus Spuren unterschiedlicher Breite und unterschiedlichen Spurabständen zusammen.

### Beispiel 11:

Ein poliertes (100) Siliciumwaferstück wird nach RCA-1-Reinigung mittels Schleuderbeschichtung mit einer Aluminium-Sol-Tinte gemäß Beispiel 4 beschichtet und bei 100 °C auf einer Heizplatte getrocknet.

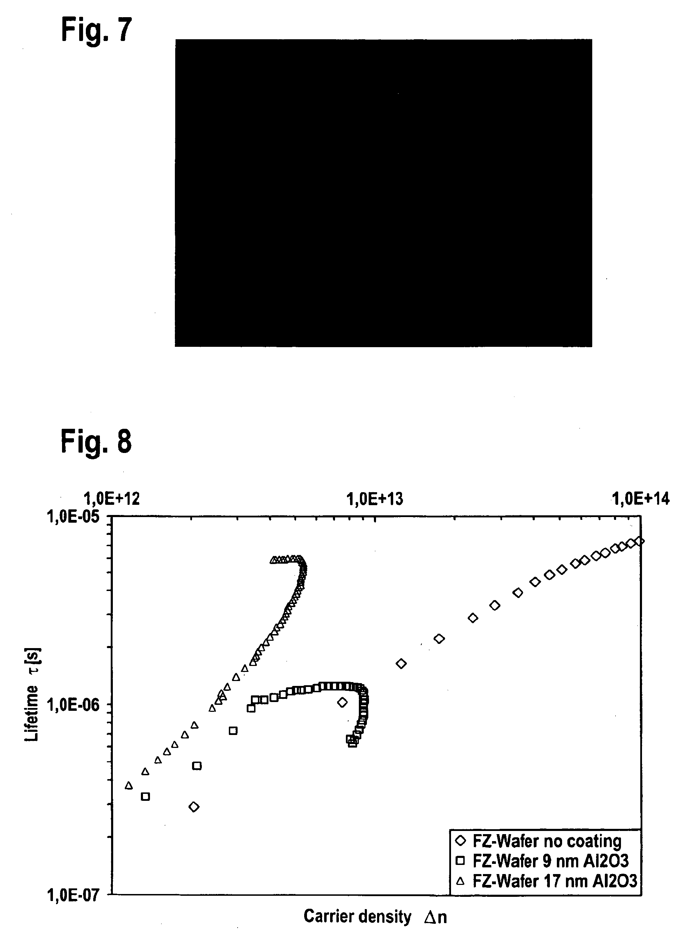

Fig. 7 zeigt das Ergebnis eines solchen mit Aluminium-Sol per Schleuderbeschichtung beschichteten polierten (100) Siliciumwaferbruchstücks

### Beispiel 12:

In einem 100 ml Rundhalskolben werden 30 g Diethylenglykolmonoethylether und 1,5 g Essigsäure vorgelegt. In dieser Lösung werden langsam 1,0 g Aluminiumtrisekbutylat gelöst. Zur Hydrolyse werden 0,2 g Wasser zugegeben und das entstehende Sol 60 Minuten auf 170 °C erhitzt. Nach dem Abkühlen bleibt ein schwach gelbes transparentes und viskoses Sol zurück, das nicht durch Komplexbildner stabilisiert werden muss. Die Massenkonzentration an Aluminiumoxid in diesem Sol beträgt etwa 1 %. Durch Erhöhung der Massenkonzentration des Aluminiumoxides in dem Sol auf 1.5 bis 2 Gew.-% tritt die Bildung eines weißen Niederschlages auf. Es ist daher davon auszugehen, dass ab einer Massenkonzentration von 1 % Aluminiumoxid die Zugabe eines stabilisierenden und schützenden Komplexbildners notwendig ist.

Das Sol wird nun mittels Schleuderbeschichtung auf einen doppelseitig polierten, p-dotierten, zuvor mit verdünnter HF geätzten (100) FZ-Wafer mit einer Rotationsgeschwindigkeit von 2000 rpm aufgebracht und anschließend bei 400 °C für 30 Minuten auf einer Heizplatte getrocknet. Die ellipsometrisch bestimmte Schichtdicke des Aluminiumoxides beträgt 9 nm. Ein zweiter Wafer wird mit dem Sol unter Anwendung der o. g. Bedingungen doppelt beschichtet. Die ellipsometrisch gemessene Schichtdicke beträgt danach 17 nm. Von diesen beiden Proben wird die Qualität der elektronischen Oberflächenpassivierung gegen eine unbeschichtete Referenzprobe mittels eines WCT-120 Photoleitfähigkeits-Trägerlebensdauer-Testers (QSSPC, quasi steady state photoconductance) untersucht.

In Fig. 8 ist die gemessene Ladungsträgerlebensdauer in Abhängigkeit der Minoritätsladungsträgerdichte dargestellt, und zwar von einer unbeschichteten Probe, sowie von mit Aluminiumoxid beschichteten Proben mit Schichtdicken von 9 und 17 nm.

Aus der Fig. 8 ergibt sich, dass die Lebensdauer der Minoritätsladungsträger nahezu unabhängig von der vorliegenden Oberflächenbehandlung ist. Die beschichteten Proben erreichten in Abhängigkeit der Injektionsdichte (Minoritätsladungsträgerdichte) vergleichbare Lebensdauern. Es ist davon auszugehen, dass die mit dem angewandten Sol und den daraus resultierenden Schichtdicken des Aluminiumoxids auf der Waferoberfläche unter den gewählten experimentellen Bedingungen nicht zur elektronischen Passivierung der Halbleiteroberfläche beitragen. Andererseits wäre eine Erhöhung der Lebensdauer der Minoritätladungsträger zu verzeichnen.

### Beispiel 13:

Ein doppelseitig poliertes, p-dotiertes (100) FZ-Siliciumwaferstück wird nach Reinigung mit verdünnter HF mittels Schleuderbeschichtung beidseitig mit einer Aluminiumoxid-Sol-Tinte gemäß Beispiel 5 beschichtet und bei 450 °C auf einer Heizplatte getrocknet. Die resultierende Schichtdicke beträgt 60 nm. Anschließend wird die Ladungsträgerlebensdauer des Wafers mittels eines WCT-120 Photoleitfähigkeits-Trägerlebensdauer-Testers (QSSPC, quasi steady state photoconductance) untersucht.

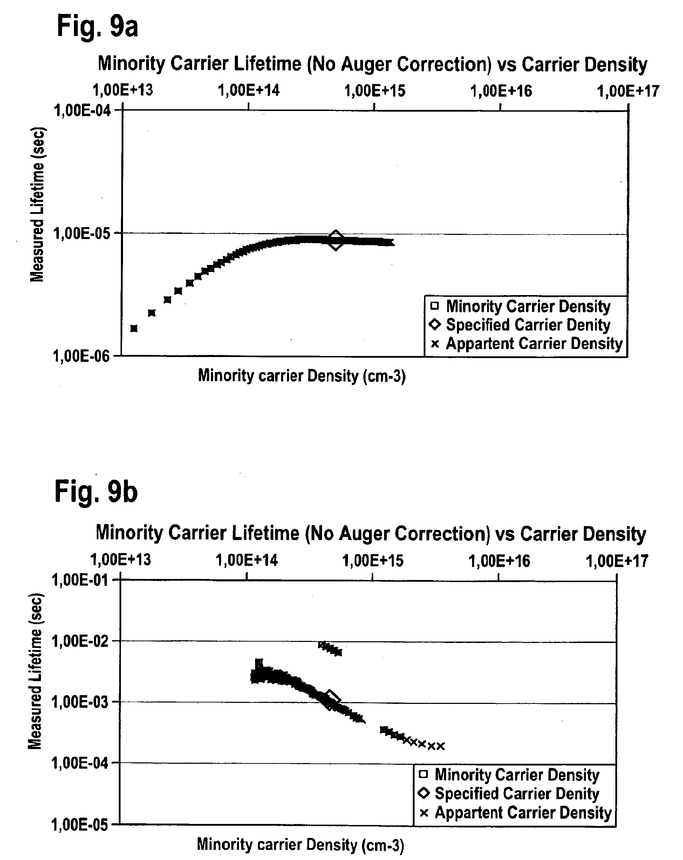

Fig. 9 zeigt die Ladungsträgerlebensdauer eines unbeschichteten Siliziumwafers (oben (a)) und eines beidseitig mit Aluminiumoxid beschichteten Siliziumwafers (unten (b)). Die Lebensdauer hat sich durch die Beschichtung um den Faktor 100 erhöht.

### Beispiel 14:

Ein einseitig poliertes, n-dotiertes (100) Cz-Siliciumwaferstück wird nach HF-Reinigung mittels Schleuderbeschichtung beidseitig mit einer Aluminiumoxid-Sol-Tinte gemäß Beispiel 5 beschichtet und bei 450 °C auf einer Heizplatte getrocknet. Die ellipsometrisch bestimmte Schichtdicke beträgt 60 nm. Anschließend wird die Ladungsträgerlebensdauer des Wafers mittels eines WCT-120 Photoleitfähigkeits-Trägerlebensdauer-Testers (QSSPC, quasi steady state photoconductance) untersucht. Als Referenzen dienen identische Waferproben, die entweder unbeschichtet oder mit Hilfe des nasschemischen Chinhydron-Methanol-Verfahrens behandelt worden sind. Beim Chinhydron-Methanol-Verfahren (Mischung aus 1,4-Benzochinon, 1,4-Benzohydrochinon und Methanol) handelt es sich um eine nasschemische und temporär wirksame, d. h. nicht langzeitstabile, elektronische Oberflächenpassivierung. Alle Waferproben werden zuvor mittels verdünnter HF geätzt.

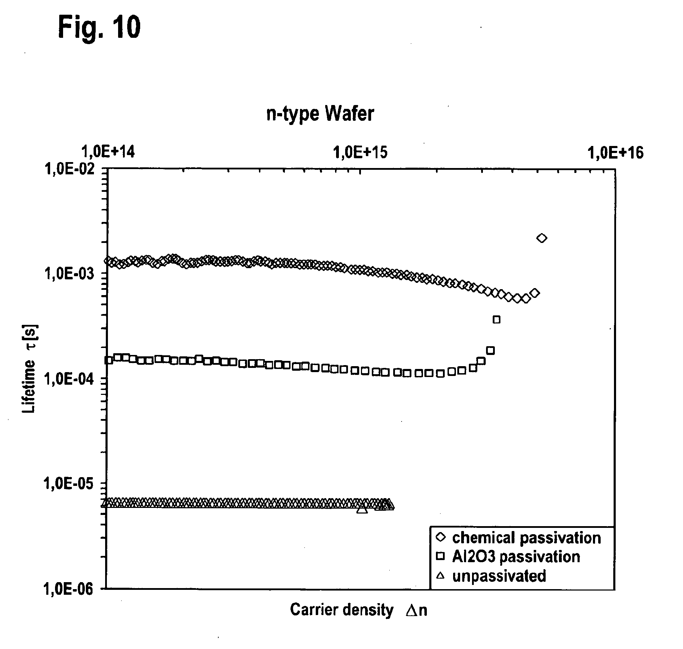

Fig. 10 zeigt Ladungträgerlebensdauern von n-dotierten Cz-Waferproben von unbeschichtete Probe (gelb, unten), von einer mit Aluminiumoxid beschichteten Probe (magenta, Mitte) und einer chemisch passivierten Probe (blau, oben). Die Lebensdauern betragen in dieser Reihenfolge (Injektionsdichte: 1E+15): 6 µs, ∼120 µs und ~1000 µs.

Gegenüber der unbeschichteten Probe ist eine Erhöhung der Lebensdauer um den Faktor 20 bestimmbar. Die Erhöhung der Trägerlebensdauer ist auf die Wirkung des Aluminiumoxids als elektronische Oberflächenpassivierung des halbleitenden Materials zurückzuführen.

### Beispiel 15:

Ein einseitig poliertes, p-dotiertes (100) Cz-Siliciumwaferstück wird nach HF-Reinigung mittels Schleuderbeschichtung beidseitig mit einer Aluminiumoxid-Sol-Tinte gemäß Beispiel 5 beschichtet und bei 450 °C auf einer Heizplatte getrocknet. Die ellipsometrisch bestimmte Schichtdicke beträgt 60 nm. Anschließend wird die Ladungsträgerlebensdauer des Wafers mittels eines WCT-120 Photoleitfähigkeits-Trägerlebensdauer-Testers (QSSPC, quasi steady state photoconductance) untersucht. Als Referenzen dienen identische Waferproben, die entweder unbeschichtet oder mit Hilfe des nasschemischen Chinhydron-Methanol-Verfahrens behandelt worden sind. Beim Chinhydron-Methanol-Verfahren (Mischung aus 1,4-Benzochinon, 1,4-Benzohydrochinon und Methanol) handelt es sich um eine nasschemische und temporär wirksame, d. h. nicht langzeitstabile, elektronische Oberflächenpassivierung. Alle Waferproben sind zuvor mittels verdünnter HF geätzt worden.

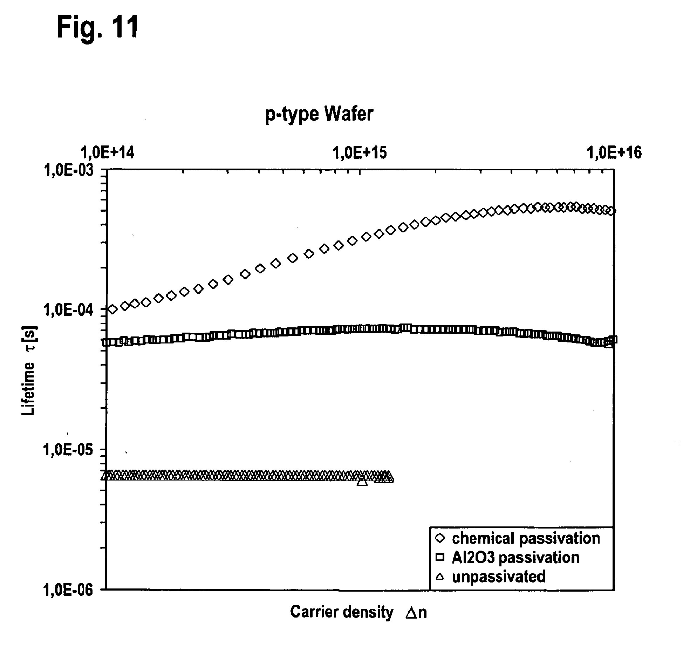

Fig. 11 zeigt die Ladungträgerlebensdauer von p-dotierten Cz-Waferproben, und zwar von einer unbeschichteten Probe (gelb, unten), einer mit Aluminiumoxid beschichteten Probe (magenta, mitte) und einer chemisch passivierten Probe (blau, oben). Die verschiedenen Längen der Lebensdauer betragen in dieser Reihenfolge (Injektionsdichte: 1 E+15): 6 µs, -65 µs und ∼300 µs.

Gegenüber der unbeschichteten Probe ist eine Erhöhung der Lebensdauer um den Faktor 10 bestimmbar. Die Erhöhung der Trägerlebensdauer ist auf die Wirkung des Aluminiumoxids als elektronische Oberflächenpassivierung des halbleitenden Materials zurückzuführen.

### Beispiel 16:

Ein doppelseitig poliertes, p-dotiertes (100) FZ-Siliciumwaferstück wird nach HF-Reinigung mittels Schleuderbeschichtung beidseitig mit einer Aluminiumoxid-Sol-Tinte gemäß Beispiel 5 beschichtet und bei 450 °C auf einer Heizplatte getrocknet. Die ellipsometrisch bestimmte Schichtdicke beträgt anschließend 60 nm. Anschließend wird die Ladungsträgerlebensdauer des Wafers mittels eines WCT-120 Photoleitfähigkeits-Trägerlebensdauer-Testers (QSSPC, quasi steady state photoconductance) untersucht. Als Referenzen dienen identische Waferproben, die entweder unbeschichtet oder mit Hilfe des nasschemischen Chinhydron-Methanol-Verfahrens behandelt worden sind. Beim Chinhydron-Methanol-Verfahren (Mischung aus 1,4-Benzochinon, 1,4-Benzohydrochinon und Methanol) handelt es sich um eine nasschemische und temporär wirksame, d. h. nicht langzeitstabile, elektronische Oberflächenpassivierung. Alle Waferproben sind zuvor mittels verdünnter HF geätzt worden.

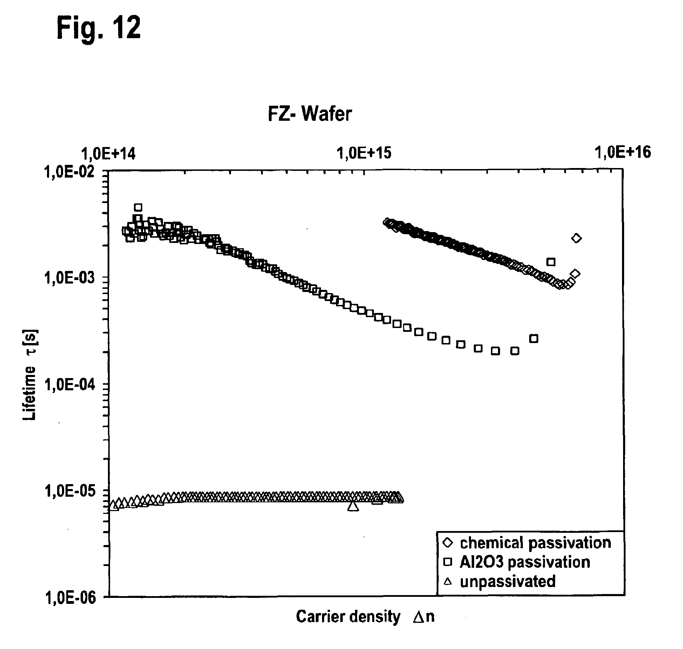

In Fig. 12 sind die Zeiten der unterschiedlichen Ladungträgerlebensdauer von p-dotierten FZ-Waferproben aufgetragen, und zwar von einer unbeschichteten Probe (gelb, unten), einer mit Aluminiumoxid beschichteten Probe (magenta, Mitte) und einer chemisch passivierte Probe (blau, oben). Die verschiedenen Längen der Lebensdauer betrugen in dieser Reihenfolge (Injektionsdichte: 1 E+15): 7 µs, ∼400 µs und >> 1000 µs.

Gegenüber der unbeschichteten Probe ist eine Erhöhung der Lebensdauer um den Faktor -60 bestimmbar. Die Erhöhung der Trägerlebensdauer ist auf die Wirkung des Aluminiumoxids als elektronische Oberflächenpassivierung des halbleitenden Materials zurückzuführen.

### Beispiel 17:

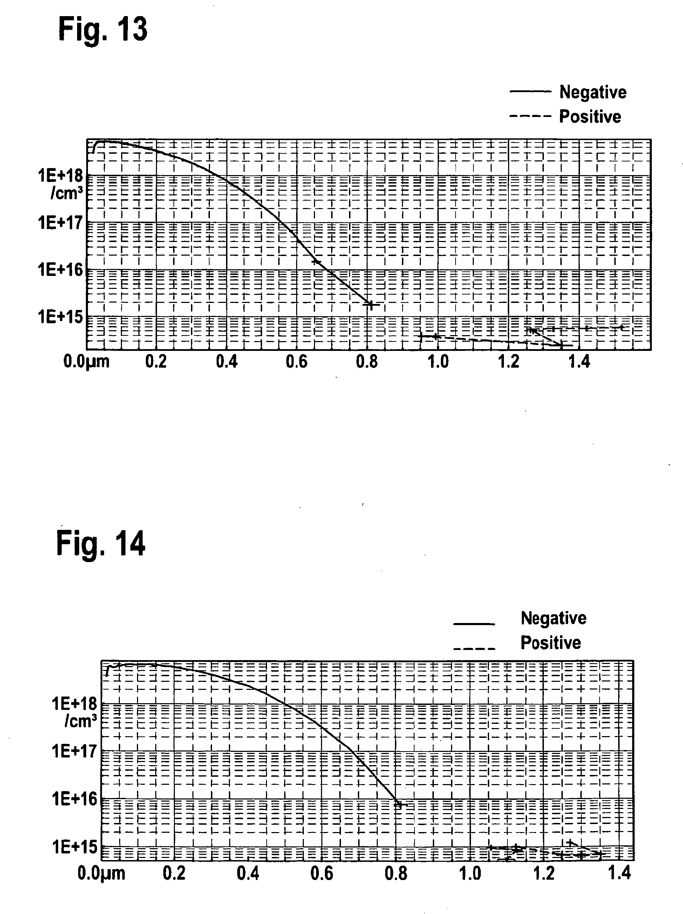

Gemäß dem Beispiel 4 wird eine auf Bor-basierende Dotiertinte hergestellt. Die Massenverhältnisse betragen darin: Diethylenglycolmonoethylether: Aluminiumtri-sec-butylat:Essigsäure : Wasser : Salicylsäure 30:5:1:1,2:1. Der Anteil an Bortrioxid beträgt 0,05 - 0,3. Nach Schleuderbeschichtung eines n-Typ Siliziumwafers (Cz, 10 Ω*cm, einseitig poliert, (100)) mit 2000 rpm für 30 s und anschließender Trocknung für 5 Minuten auf einer Hotplate bei 300°C resultiert eine Schichtdicke von etwa 70 nm. Diese Probe wird einem Diffusionsprozess in einem Muffelofen unter normaler Atmosphärenbedingungen unterworfen (Diffusionsbedingungen: 30 Minuten bei 950°C). In Fig. 13 und 14 sind die resultierenden Dotierprofile von Proben mit den relativen Massenverhältnissen am Boroxid von 0,15 und 0,3 dargestellt. Die Dotierprofile sind mittels ECV-Technik (electrochemical capacitance voltage profiling, elektrochemische Kapazitäts-Spannungs-Profilierung) bestimmt worden.

In Fig. 13 ist ein Diffusionsprofil der Bor-Dotiertinte mit einem relativen Massenanteil von 0,15 (rote Kurve: p- bzw. Bor-Dotierung infolge der Exposition der Waferoberfläche zur getrockneten Tinte, blaue Kurve: n- oder Phosphor-Basisdotierung) gezeigt. Der Schichtwiderstand der Probe beträgt 464 Ω/square.

In Fig. 14 ist ein Diffusionsprofil der Bor-Dotiertinte mit einem relativen Massenanteil von 0,3 (rote Kurve: p- bzw. Bor-Dotierung infolge der Exposition der Waferoberfläche zur getrockneten Tinte, blaue Kurve: n- oder Phosphor-Basisdotierung) gezeigt. Der Schichtwiderstand der Probe beträgt 321 Ω/square.

### Beispiel 18:

In einem 100 ml Rundhalskolben werden 1,5 g Salicylsäure und 1 g Acetylaceton in 25 ml Diethylenglykolmonoethylether vorgelegt. Zu der Lösung werden 5,7 g Aluminiumtrisekbutylat zugegeben und für 10 Minuten gerührt. Als Dotand werden zu dieser Lösung 0,75 g Dibortrioxid zugegeben und bis zur rückstandslosen Lösung des Boroxids gerührt. Zur Neutralisation des Butylats und der Einstellung des pH Werts der Tinte werden 1 g Essigsäure zugegeben und erneut für 10 Minuten gerührt. Zur Hydrolyse des partiell geschützten Aluminiumalkoholats werden 1,7 g Wasser zugegeben und die leicht gelbe Lösung wird nach 10 Minuten Rühren zur Alterung stehen gelassen. Der Feststoffgehalt kann auf bis zu 6% erhöht werden. Die Tinte zeigt eine Stabilität von > 3 Monaten bei idealen Beschichtungseigenschaften und effizienter Trocknung. Nach Schleuderbeschichtung eines n-Typ Siliciumwaferstücks (Cz, 10 Ω*cm, wird einseitig poliert, (100)) bei 1000 rpm und anschließender 30 minütiger Diffusion bei 1000°C in einem normalen Muffelofen unter normalen Atmosphärenbedingungen, läßt sich mittels ECV-Technik (electrochemical capacitance voltage profiling, elektrochemische Kapazitäts-Spannungs-Profilierung) das in Fig. 14 gezeigte Dotierprofil mit einem zugehörigen Schichtwiderstand von <80 Ω/square messen.

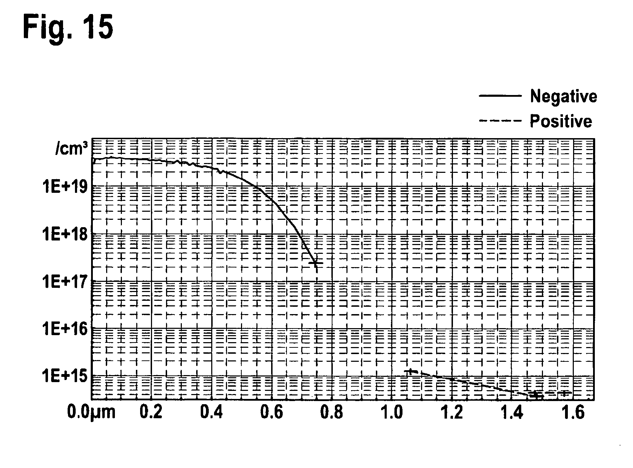

In Fig. 15 ist das Diffusionsprofil der Bor-Dotiertinte gemäß Beispiel 18 gezeigt (rote Kurve: p- bzw. Bor-Dotierung infolge der Exposition der Waferoberfläche zur getrockneten Tinte, blaue Kurve: n- oder Phosphor-Basisdotierung). Der Schichtwiderstand der Probe betrug 65 Ω/square.

## Patentansprüche

1. Verwendung druckbarer, sterisch stabilisierter Tinten zur Ausbildung von dichten, homogenen Al₂O₃-Beschichtungen oder von gemischten Al₂O₃-Hybrid-Schichten als Diffusionsbarriere und zur elektronischen oder elektrischen Passivierung, wobei
a) Tinten verwendet werden, worin die schichtbildenden Komponenten im Verhältnis zueinander so eingestellt sind, dass der Feststoffgehalt zwischen 0,5 und 10 Gew.-%, bevorzugt zwischen 1 und 6 Gew.-%, liegt,
b) die verwendeten Tinten sterisch stabilisiert sind durch Vermischen mit mindestens einer hydrophoben Komponente, mindestens einer hydrophilen Komponente, ausgewählt aus der Gruppe Acetylaceton, Dihydroxybenzoesäure und Trihydroxybenzoesäure oder deren strukturverwandte Verbindungen und gegebenenfalls mit mindestens einem Chelatbildner,
und
c) die Tinten zur Hydrolyse der enthaltenen Alkoxide mit Wasser in einem molaren Verhältnis von Wasser zu Precursor zwischen 1 : 1 und 1 : 9, bevorzugt zwischen 1 : 1,5 und 1 : 2,5, versetzt werden.

2. Verwendung von Tinten gemäß Anspruch 1, die Precursoren zur Bildung von Al₂O₃ und zur Bildung von einem oder mehreren Oxid(en) der Elemente, ausgewählt aus der Gruppe Bor-, Gallium-, Silicium-, Germanium-, Zink-, Zinn-, Phosphor-, Titan-, Zirkonium-, Yttrium-, Nickel-, Cobalt-, Eisen-, Cer-, Niob-, Arsen- und Blei-Oxide, enthalten, wobei die Tinten durch Einbringen entsprechender Precursoren in die Tinte erhalten werden.

3. Verwendung von Tinten gemäß der Ansprüche 1 oder 2, welche mindestens eine hydrophobe Komponente ausgewählt aus der Gruppe 1,3-Cyclohexadion, Salicylsäure und strukturverwandten Verbindungen enthalten und mindestens eine hydrophilen Verbindung ausgewählt aus der Gruppe Acetylaceton, Dihydroxybenzoesäure und Trihydroxybenzoesäure oder deren strukturverwandte Verbindungen, Chelatbildner wie Ethylendiämintetraessigsäure (EDTA), Diethylentriaminpeantaessigsäure (DETPA), Nitrilotriessigsäure (NTA), Ethylendiaminetetramethylenephosphonsäure (EDTPA) und Diethylentriaminpentamethylenephosphonsäure (DETPPA) oder strukturverwandter Komplexbildner oder entsprechender Chelatbildner enthalten.

4. Verwendung von Tinten gemäß der Ansprüche 1, 2 oder 3, welche Lösungsmittel enthalten, ausgewählt aus der Gruppe der niedrig siedenden Alkohole, bevorzugt ausgewählt aus der Gruppe Ethanol und Isopropanol, und mindestens einen hochsiedenden Alkohol, ausgewählt aus der Gruppe der hochsiedenden Glykolether, bevorzugt ausgewählt aus der Gruppe Diethylenglykolmonoethylether, Ethylenglykolmonobutylether und Diethylenglykolmonobutylether oder deren Mischungen, sowie gegebenenfalls polare Lösungsmittel aus gewählt aus der Gruppe Aceton, DMSO, Sulfolan und Ethylacetat oder ähnliche polare Lösungsmittel.

5. Verwendung von Tinten gemäß der Ansprüche 1, 2, 3 oder 4, welche einen sauren pH-Wert im Bereich von 4 - 5 aufweisen und als Säuren eine oder mehrere organische Säuren enthalten, die zu einer rückstandsfreien Trocknung führen.

6. Verwendung von Tinten gemäß einem oder mehreren der Ansprüche 1 bis 5 zur Herstellung einer Diffusionsbarriere, eines gedruckten Dielektrikums, einer elektronischen und elektrischen Passivierung, einer Antireflexbeschichtung, einer mechanischen Schutzschicht gegen Verschleiß, einer chemischen Schutzschicht gegen Oxidation oder Säureeinwirkung.

7. Verwendung von Tinten gemäß einem oder mehreren der Ansprüche 1 - 5 zur Herstellung von Hybridmaterialien mit einfachen und polymeren Bor- und Phosphoroxiden sowie deren Alkoxiden zur arealen und lokalen Dotierung von Halbleitern, vorzugsweise von Silicium.

8. Verwendung von Tinten gemäß einem oder mehreren der Ansprüche 1 - 5 zur Herstellung von Hybridschichten, die einen Bortrioxidgehalt im Bereich von 5 - 55 Mol-%, bevorzugt im Bereich von 20 - 45 Mol-%, aufweisen.

9. Verwendung von Tinten gemäß einem oder mehreren der Ansprüche 1 bis 5 zur Herstellung von Al₂O₃₋Schichten als Natrium und Kalium Diffusionsbarrieren in der LCD Technik.

10. Verfahren zur Herstellung von reinen rückstandsfreien amorphen Al₂O₃-Schichten auf mono- oder multikristallinen Siliziumwafern, Saphirwafern, Dünnschichtsolarmodulen, mit funktionalen Materialien (z.B. ITO, FTO, AZO, IZO oder vergleichbare) beschichteten oder unbeschichteten Gläsern, Stahlelementen und Legierungen, sowie auf sonstigen in der Mikroelektronik verwendeten Materialien, **dadurch gekennzeichnet, dass** die Trocknung nach dem Auftragen einer dünnen Schicht Tinte gemäß einem oder mehreren der Ansprüche 1 bis 5 bei Temperaturen zwischen 300 und 1000 °C, bevorzugt bei 300 bis 450 °C erfolgt.

11. Verfahren gemäß Anspruch 10, **dadurch gekennzeichnet, dass** vor dem Auftrag der Tinte, die Oberfläche, die gegebenenfalls hydrophob oder hydrophil terminiert vorliegt, gereinigt wird, vorzugsweise durch Ätzen mit HF-Lösung oder Wasser.

12. Verfahren gemäß der Ansprüche 10 oder 11, **dadurch gekennzeichnet, dass** durch Trocknung und Temperung bei Temperaturen ab 1000 °C harte, kristalline Schichten mit vergleichbaren Eigenschaften wie Korund gebildet werden.

13. Verfahren gemäß der Ansprüche 10 oder 11, **dadurch gekennzeichnet, dass** die Trocknung innerhalb weniger Minuten, vorzugsweise innerhalb einer Zeit von weniger als 5 Minuten, erfolgt, wobei sich aus der aufgedruckten Sol-Gel-Zusammensetzung eine Schicht mit einer Dicke im Bereich von 20 bis 300 nm, vorzugsweise von weniger als 100 nm ausbildet, welche Oberflächen-passivierende Eigenschaften aufweist.

14. Verfahren nach einem oder mehreren der Ansprüche 10 bis 13 zur Herstellung von reinen, rückstandsfreien, amorphen strukturierbaren Al₂O₃-Schichten, **dadurch gekennzeichnet, dass** die Trocknung nach dem Auftragen einer dünnen Schicht Tinte gemäß einem oder mehreren der Ansprüche 1 bis 7 bei Temperaturen zwischen 300 °C und 500 °C erfolgt, gegebenenfalls gefolgt von einem Temperschritt, der bei Temperaturen bei 350 bis 550 °C unter Stickstoff- und/oder Formiergasatmosphäre erfolgt.

15. Druckbare, sterisch stabilisierte Tinten zur Ausbildung von dichten, homogenen Al₂O₃-Beschichtungen oder von gemischten Al₂O₃-Hybrid-Schichten als Diffusionsbarriere und zur elektronischen oder elektrischen Passivierung, **dadurch gekennzeichnet, dass** sie
a) schichtbildende Komponenten enthalten, die im Verhältnis zueinander so eingestellt sind, dass der Feststoffgehalt in der Tinte zwischen 0,5 und 10 Gew.-%, bevorzugt zwischen 1 und 6 Gew.-%, liegt,
b) sterisch stabilisiert sind durch Vermischen mit mindestens einer hydrophoben Komponente, mindestens einer hydrophilen Komponente, ausgewählt aus der Gruppe Acetylaceton, Dihydroxybenzoesäure und Trihydroxybenzoesäure oder deren strukturverwandte Verbindungen und
gegebenenfalls mit mindestens einem Chelatbildner,
und
c) die darin enthaltenen Alkoxide zur Hydrolyse mit Wasser in einem molaren Verhältnis von Wasser zu Precursor zwischen 1 : 1 und 1 : 9, bevorzugt zwischen 1 : 1,5 und 1 : 2,5, versetzt werden.

## Claims

1. Use of printable, sterically stabilised inks for the formation of impermeable, homogeneous Al₂O₃ coatings or of mixed Al₂O₃ hybrid layers as diffusion barrier and for electronic or electrical passivation, where
a) inks are used in which the ratio of the layer-forming components to one another is set in such a way that the solids content is between 0.5 and 10% by weight, preferably between 1 and 6% by weight,
b) the inks used have been sterically stabilised by mixing with at least one hydrophobic component, at least one hydrophilic component selected from the group acetylacetone, dihydroxybenzoic acid and trihydroxybenzoic acid or structurally related compounds thereof and optionally with at least one chelating agent,
and
c) water is added to the inks for hydrolysis of the alkoxides present in a molar ratio of water to precursor between 1 : 1 and 1 : 9, preferably between 1 : 1.5 and 1 : 2.5.

2. Use of inks according to Claim 1 which comprise precursors for the formation of Al₂O₃ and for the formation of one or more oxide(s) of the elements selected from the group boron, gallium, silicon, germanium, zinc, tin, phosphorus, titanium, zirconium, yttrium, nickel, cobalt, iron, cerium, niobium, arsenic and lead oxides, where the inks are obtained by the introduction of corresponding precursors into the ink.

3. Use of inks according to Claim 1 or 2 which comprise at least one hydrophobic component selected from the group 1,3-cyclohexadione, salicylic acid and structurally related compounds and at least one hydrophilic compound selected from the group acetylacetone, dihydroxybenzoic acid and trihydroxybenzoic acid or structurally related compounds thereof, chelating agents, such as ethylenediaminetetraacetic acid (EDTA), diethylenetriaminepentaacetic acid (DETPA), nitrilotriacetic acid (NTA), ethylenediaminetetramethylenephosphonic acid (EDTPA) and diethylenetriaminepentamethylenephosphonic acid (DETPPA), or structurally related complexing agents or corresponding chelating agents.

4. Use of inks according to Claim 1, 2 or 3 which comprise solvents selected from the group of low-boiling alcohols, preferably selected from the group ethanol and isopropanol, and at least one high-boiling alcohol selected from the group of high-boiling glycol ethers, preferably selected from the group diethylene glycol monoethyl ether, ethylene glycol monobutyl ether and diethylene glycol monobutyl ether or mixtures thereof, and optionally polar solvents selected from the group acetone, DMSO, sulfolane and ethyl acetate, or similar polar solvents.

5. Use of inks according to Claim 1, 2, 3 or 4 which have an acidic pH in the range 4 - 5 and comprise, as acids, one or more organic acids which result in residue-free drying.

6. Use of inks according to one or more of Claims 1 to 5 for the production of a diffusion barrier, a printed dielectric, an electronic and electrical passivation, an antireflection coating, a mechanical protection layer against wear, a chemical protection layer against oxidation or the action of acid.

7. Use of inks according to one or more of Claims 1 - 5 for the preparation of hybrid materials comprising simple and polymeric boron and phosphorus oxides and alkoxides thereof for the full-area and local doping of semiconductors, preferably silicon.

8. Use of inks according to one or more of Claims 1 - 5 for the production of hybrid layers which have a boron trioxide content in the range 5 - 55 mol%, preferably in the range 20 - 45 mol%.

9. Use of inks according to one or more of Claims 1 to 5 for the production of Al₂O₃ layers as sodium and potassium diffusion barriers in LCD technology.

10. Process for the production of pure, residue-free, amorphous Al₂O₃ layers on mono- or multicrystalline silicon wafers, sapphire wafers, thin-film solar modules, glasses coated with functional materials (for example ITO, FTO, AZO, IZO or the like), uncoated glasses, steel elements and alloys, and on other materials used in microelectronics, **characterised in that**, after application of a thin layer of ink according to one or more of Claims 1 to 5, the drying is carried out at temperatures between 300 and 1000°C, preferably at 300 to 450°C.

11. Process according to Claim 10, **characterised in that**, before application of the ink, the surface, which is optionally hydrophobically or hydrophilically terminated form, is cleaned, preferably by etching with HF solution or water.

12. Process according to Claim 10 or 11, **characterised in that** drying and heat-treatment at temperatures from 1000°C gives hard, crystalline layers having comparable properties to corundum.

13. Process according to Claim 10 or 11, **characterised in that** the drying is carried out over the course of a few minutes, preferably over the course of a time of less than 5 minutes, where a layer having a thickness in the range from 20 to 300 nm, preferably of less than 100 nm, which has surface-passivating properties forms from the printed-on sol-gel composition.

14. Process according to one or more of Claims 10 to 13 for the production of pure, residue-free, amorphous, structurable Al₂O₃ layers, **characterised in that**, after application of a thin layer of ink according to one or more of Claims 1 to 7, the drying is carried out at temperatures between 300°C and 500°C, optionally followed by a heat-treatment step, which is carried out at temperatures of 350 to 550°C under a nitrogen and/or forming-gas atmosphere.

15. Printable, sterically stabilised inks for the formation of impermeable, homogeneous Al₂O₃ coatings or of mixed Al₂O₃ hybrid layers as diffusion barrier and for electronic or electrical passivation, **characterised in that** they
a) comprise layer-forming components in which the ratio thereof to one another is set in such a way that the solids content in the ink is between 0.5 and 10% by weight, preferably between 1 and 6% by weight,
b) have been sterically stabilised by mixing with at least one hydrophobic component, at least one hydrophilic component selected from the group acetylacetone, dihydroxybenzoic acid and trihydroxybenzoic acid or structurally related compounds thereof and optionally with at least one chelating agent,
and
c) water is added to the alkoxides present therein for hydrolysis in a molar ratio of water to precursor between 1 : 1 and 1 : 9, preferably between 1 : 1.5 and 1 : 2.5.

## Revendications

1. Utilisation d'encres imprimables stabilisées de façon stérique pour la formation de revêtements imperméables en Al₂O₃ homogène ou de couches hybrides en Al₂O₃ mélangé en tant que barrière de diffusion et pour la passivation électronique ou électrique, dans laquelle :
a) on utilise des encres dans lesquelles le rapport des composants de formation de couche les uns par rapport aux autres est établi de telle sorte que la teneur en solides soit entre 0,5 et 10% en poids, de façon préférable entre 1 et 6% en poids,
b) les encres utilisées ont été stabilisées de façon stérique en effectuant un mélange avec au moins un composant hydrophobe, au moins un composant hydrophile choisi parmi le groupe constitué par acétylacétone, acide dihydroxybenzoïque et acide trihydroxybenzoïque ou leurs composés structurellement afférents et en option, avec au moins un agent chélatant,
et
c) de l'eau est ajoutée aux encres pour l'hydrolyse des alcoxydes présents selon un rapport molaire eau sur précurseur entre 1 : 1 et 1 : 9, de façon préférable entre 1 : 1,5 et 1 : 2,5.

2. Utilisation d'encres selon la revendication 1, lesquelles comprennent des précurseurs pour la formation de l'Al₂O₃ et pour la formation d'un ou de plusieurs oxyde(s) des éléments choisis parmi le groupe constitué par oxydes de bore, de gallium, de silicium, de germanium, de zinc, d'étain, de phosphore, de titane, de zirconium, d'yttrium, de nickel, de cobalt, de fer, de cérium, de niobium, d'arsenic et de plomb, où les encres sont obtenues au moyen de l'introduction de précurseurs correspondants dans l'encre.

3. Utilisation d'encres selon la revendication 1 ou 2, lesquelles comprennent au moins un composant hydrophobe choisi parmi le groupe constitué par 1,3-cyclohexadione, acide salicylique et leurs composés structurellement afférents et au moins un composé hydrophile choisi parmi le groupe constitué par acétylacétone, acide dihydroxybenzoïque et acide trihydroxybenzoïque ou leurs composés structurellement afférents, des agents chélatants tels que l'acide éthylènediaminetétraacétique (EDTA), l'acide diéthylènetriaminepentaacétique (DETPA), l'acide nitrilotriacétique (NTA), l'acide éthylènediaminetétraméthylènephosphonique (EDTPA) et l'acide diéthylènetriaminepentaméthylènephosphonique (DETPPA), ou des agents complexants structurellement afférents ou des agents chélatants correspondants.

4. Utilisation d'encres selon la revendication 1, 2 ou 3, lesquelles comprennent des solvants choisis parmi le groupe constitué par des alcools à point d'ébullition bas, de façon préférable choisis parmi le groupe constitué par éthanol et isopropanol, et au moins un alcool à point d'ébullition élevé choisi parmi le groupe constitué par des glycoléthers à point d'ébullition élevé, de façon préférable choisis parmi le groupe constitué par diéthylèneglycolmonoéthyléther, éthylèneglycolmonobutyléther et diéthylèneglycolmonobutyléther ou des mélanges afférents, et en option, des solvants polaires choisis parmi le groupe constitué par acétone, DMSO, sulfolane et éthylacétate, ou des solvants polaires similaires.

5. Utilisation d'encres selon la revendication 1, 2, 3 ou 4, lesquelles présentent un pH acide dans la plage 4 - 5 et comprennent, en tant qu'acides, un ou plusieurs acide(s) organique(s) qui conduit/conduisent à un séchage exempt de résidus.

6. Utilisation d'encres selon une ou plusieurs des revendications 1 à 5 pour la fabrication d'une barrière de diffusion, d'un diélectrique imprimé, d'une passivation électronique et électrique, d'un revêtement antireflet, d'une couche de protection mécanique vis-à-vis de l'usure, d'une couche de protection chimique vis-à-vis de l'oxydation ou de l'action d'un acide.

7. Utilisation d'encres selon une ou plusieurs des revendications 1 - 5 pour la préparation de matériaux hybrides comprenant des oxydes de bore et de phosphore simples et polymériques et leurs alcoxydes afférents pour le dopage pleine aire et local de semiconducteurs, de façon préférable du silicium.

8. Utilisation d'encres selon une ou plusieurs des revendications 1 - 5 pour la fabrication de couches hybrides qui présentent une teneur en trioxyde de bore dans la plage 5 - 55 en pourcentage molaire, de façon préférable dans la plage 20 - 45 en pourcentage molaire.

9. Utilisation d'encres selon une ou plusieurs des revendications 1 à 5 pour la fabrication de couches en Al₂O₃ telles que des barrières de diffusion à l'encontre du sodium et du potassium pour la technologie LCD.

10. Procédé pour la fabrication de couches pures en Al₂O₃ amorphe exempt de résidus sur des plaquettes en silicium monocristallin ou multicristallin, des plaquettes en saphir, des modules solaires à film mince, des verres revêtus de matériaux fonctionnels (par exemple ITO, FTO, AZO, IZO ou similaire), des verres non revêtus, des éléments en acier et des alliages d'acier, et sur d'autres matériaux utilisés en microélectronique, **caractérisé en ce que**, après l'application d'une couche mince d'encre selon une ou plusieurs des revendications 1 à 5, le séchage est mis en oeuvre à des températures entre 300 et 1000°C, de façon préférable entre 300 et 450°C.

11. Procédé selon la revendication 10, **caractérisé en ce que**, avant l'application de l'encre, la surface, qui est en option sous sa forme terminée hydrophobe ou hydrophile, est nettoyée, de façon préférable par gravure à l'aide d'une solution de HF ou d'eau.

12. Procédé selon la revendication 10 ou 11, **caractérisé en ce qu'**un séchage et traitement thermique à des températures à partir de 1000°C permet d'obtenir des couches cristallines dures présentant des propriétés comparables à celles du corindon.

13. Procédé selon la revendication 10 ou 11, **caractérisé en ce que** le séchage est mis en oeuvre sur quelques minutes, de façon préférable sur un temps inférieur à 5 minutes, où une couche présentant une épaisseur dans la plage de 20 à 300 nm, de façon préférable inférieure à 100 nm, laquelle présente des propriétés de passivation de surface, se forme à partir d'une composition sol-gel imprimée.

14. Procédé selon une ou plusieurs des revendications 10 à 13 pour la fabrication de couches en Al₂O₃ structurable, amorphe, pur et exempt de résidus, **caractérisé en ce que**, après l'application d'une couche mince d'encre selon une ou plusieurs des revendications 1 à 7, le séchage est mis en oeuvre à des températures entre 300°C et 500°C, lequel séchage est en option suivi par une étape de traitement thermique, laquelle est mise en oeuvre à des températures de 350 à 550°C sous une atmosphère d'azote et/ou de formation de gaz.

15. Encres imprimables stabilisées de façon stérique pour la formation de revêtements imperméables en Al₂O₃ homogène ou de couches hybrides en Al₂O₃ mélangé en tant que barrière de diffusion et pour une passivation électronique ou électrique, **caractérisées en ce qu'**elles :
a) comprennent des composants de formation de couche dont le rapport les uns par rapport aux autres est établi de telle sorte que la teneur en solides dans l'encre soit entre 0,5 et 10% en poids, de façon préférable entre 1 et 6% en poids,
b) ont été stabilisées de façon stérique en effectuant un mélange avec au moins un composant hydrophobe, au moins un composant hydrophile choisi parmi le groupe constitué par acétylacétone, acide dihydroxybenzoïque et acide trihydroxybenzoïque ou leurs composés structurellement afférents et en option, avec au moins un agent chélatant,
et
c) de l'eau est ajoutée aux alcoxydes présents pour une hydrolyse selon un rapport molaire eau sur précurseur entre 1 : 1 et 1 : 9, de façon préférable entre 1 : 1,5 et 1 : 2,5.
